# EUROPEAN PATENT APPLICATION

(11) **EP 2 377 908 A1**
(43) Date of publication of application: **19.10.2011**
(21) Application number: 09835157.0
(22) Date of filing: 29.09.2009
(51) Int. Cl.: C09K 11/79, H01L 27/15

(54) **OXYNITRIDE PHOSPHOR, METHOD FOR PREPARING THE SAME, AND LIGHT-EMITTING DEVICE**

(30) Priority: 22.12.2008 KR 20080131419; 21.09.2009 KR 20090089233
(71) Applicant: Kumho Electric, Inc., Seoul 121-050 (KR)
(72) Inventor: KIM, Kwang Bok, Seoul 158-753 (KR); KANG, Jun Gill, Daejeon 302-741 (KR); OH, Sung Il, Daejeon 302-795 (KR); JEONG, Young Kwang, Daejeon 300-741 (KR)
(74) Representative: Rauh, Peter
(86) International application number: PCT/KR2009/005573
(87) International publication number: WO 2010/074391

(57) **Abstract**

The present invention relates to an oxynitride phosphor, a method for preparing the same, and a light-emitting device. More specifically, the present invention provides the oxynitride phosphor including crystals represented by the following Chemical Formula, a method for preparing the same, and a light-emitting device including the oxynitride phosphor. The invention includes the crystals' represented by the following Chemical Formula to obtain high light-emitting efficiency. [Chemical Formula] (_{A(1-p-q)}BₚC_{q})ₐD_{b}Si_{c}O_{d}Nₑ:xEu²⁺, yRe³⁺, Zq) wherein A, B, and C are +2 metals, but different metals from one another; D is metals of Group 3; Re is +3 metals; Q is a flux; p and q are 0 < p < 1.0 and 0 ≤ q < 1.0; a, b, c, d, and e are 1.0 ≤ a ≤ 2.0, 0 ≤ b ≤ 4.0, 0 < c ≤ 1.0, 0 < d ≤ 1.0, and 0 < e ≤ 2.0; x, y, and z are 0 < x ≤ 0.25, 0 ≤ y ≤ 0.25, and 0 ≤ z ≤ 0.25.

## Description

### BACKGROUND OF THE INVENTION

The present invention relates to an oxynitride phosphor, a method for preparing the same, and a light-emitting device, and more specifically, to the oxynitride phosphor with an excellent light-emitting efficiency that is obtained by including oxynitride crystals having specific components, the method for preparing the oxynitride phosphor at a low price, and the light-emitting device including the oxynitride phosphor.

Generally, a light-emitting device includes a luminous element (Excitation Light Source), such as Light-Emitting Diode (LED), and the like, and a phosphor as a wavelength conversion material. The phosphor can be excited by the excitation light source (LED and the like) to emit white complex light. Generally, the phosphor includes a host material and rare earth elements as an activator.

The phosphor is for example an oxide phosphor, and YAG-based oxide represented by Chemical Formula (Component Formula), i.e., (Y)₃(Al, Ga)₅O₁₂:Ce has been usually used as the phosphor. The light-emitting device using the same can implement a white color by combination of yellow color emitted from YAG-based oxide phosphor and a blue color emitted from LED. In addition, the oxide phosphor, in which Gd is substituted instead of Y and Ge is substituted instead of Al as a host material in the YAG-based phosphor has been also suggested.

However, the oxide phosphor, such as YAG-based phosphor and the like is being blamed for its disadvantages, such as, the increase of the cost due to the demand of a high temperature when preparing the oxide phosphor and also the difficulty of color control to a white color due to the lack of light emitting in green and red colors range.

In addition, Japanese Publication Patent No. 2002-531956 (Preceding Patent Document 1) discloses a white light-emitting device using a green phosphor represented by Chemical Formula, i.e., (Sr, Ca, Ba) (Al, Ga)₂S₄:Eu²⁺ and a red phosphor represented by Chemical Formula, i.e., (Ca, Sr)S:Eu²⁺ as a sulfide phosphor. However, it emits a white-based color as a mixed color of blue light around 460 nm and yellowish green light around 565 nm, but the light-emitting intensity around 500 nm is insufficient.

In addition, Japanese Publication Patent No. 2001-214162 (Preceding Patent Document 2) discloses an oxynitride phosphor represented by Si-O-N, Mg-Si-O-N, Ca-Al-Si-O-N, and the like as an oxynitride phosphor, and Japanese Publication Patent No. 2002-76434 (Preceding Patent Document 3) discloses an oxynitride phosphor represented by Ca-Al-Si-O-N, in which Eu is activated. However, it is known that the phosphors have low light-emitting luminance so that it is insufficient to be used in a light-emitting device.

To achieve this, Korean Publication Patent No. 2005-0062623 (Preceding Patent Document 4) discloses an oxynitride phosphor that is consisted of crystals including at least one element of Group II selected from the group consisting of Be, Mg, Ca, Sr, Ba, and Zn; at least one element of Group IV selected from the group consisting of C, Si, Ge, Sn, Ti, Zr, and Hf; and rare earth elements as an activator (R), in which the oxynitride phosphor is a phosphor that effectively emit in short wavelength range of visible light due to high light-emitting efficiency.

However, the phosphor disclosed in the Preceding Patent Document 4 has a disadvantage such that it does not have a good light-emitting efficiency (Light-Emitting Luminance, and the like) because the crystals are unstable. In addition, the Preceding Patent Document 4 has a disadvantage such that the price of raw materials is high because a nitride is used as a starting raw material, and also high calcining temperature and pressure are required due to the use of the nitride so that it is difficult to provide at a low price.

[Preceding Patent Document 1] Japanese Publication Patent No. 2002-531956

[Preceding Patent Document 2] Japanese Publication Patent No. 2001-214162

[Preceding Patent Document 3] Japanese Publication Patent No. 2002-76434

[Preceding Patent Document 4] Korean Publication Patent No. 2005-0062623

### SUMMARY OF THE INVENTION

The present invention is to solve the conventional technical problems as mentioned above, and an object of the present invention is to provide an oxynitride phosphor with high light-emitting efficiency that can be provided at a low price by including oxynitride crystals having specific components, a method for preparing the same, and a light-emitting device including the oxynitride phosphor.

In order to achieve the object, the present invention provides the oxynitride phosphor including crystals represented by the following Chemical Formula:

[Chemical Formula] (A_{(1-p-q)} BₚC_{q})ₐD_{b}Si_{c}O_{d}Nₑ: xEu²⁺, yRe³⁺, zQ

(In the above Chemical Formula,

A, B, and C are +2 metals, but different metals from one another;

D is metals of Group 3;

Re is +3 metals;

Q is a flux;

p and q are 0 < p < 1.0 and 0 ≤ q < 1.0;

a, b, c, d, and e are 1.0 ≤ a ≤ 2.0, 0 ≤ b ≤ 4.0, 0 < c ≤ 1.0, 0 < d ≤ 1.0, and 0 < e ≤ 2.0 ; and

x, y, and z are 0 < x ≤ 0.25, 0 ≤ y ≤ 0.25, and 0 ≤ z ≤ 0.25)

In addition, the present invention relates a method for preparing the oxynitride phosphor, comprising:

(1) first step for mixing raw materials including A precursor (A is +2 metals), B precursor (B is +2 metals, but different metals from A), C precursor (C is +2 metals, but different metals from A and B), D precursor (D is elements of Group 3), Si precursor, N precursor, Eu precursor, Re precursor (Re is +3 metals), and Q precursor (Q is the flux), in which the raw materials are mixed by controlling the contents of each of the precursors to be contented with the above Chemical Formula; and

(2) Second step for calcining by injecting the raw materials to a calcining furnace.

At this time, the second step preferably includes a) step for increasing a temperature up to 800 °C ∼ 1300 °C while injecting an ammonia gas in 5~15 mL/min in the calcining furnace; and

b) step for maintaining for 2~5 hours at the temperature of 800 °C ∼ 1300 °C in the presence of the ammonia gas.

Furthermore, the present invention provides the light-emitting device including excitation light source and the phosphor, in which the phosphor includes the oxynitride phosphor according the present invention.

### BRIEF DESCRIPTION OF THE DRAWINGS

FIG. 1 is a graph showing the results of luminescence and excitation spectra of a phosphor [(Ba_{0.5}Sr_{0.5}) Si_{0.56}ON_{0.75}: 0.075Eu²⁺, 0.04Cl⁻] prepared according to Example of the present invention.

Fig. 2 is SEM image of a phosphor [(Ba_{0.5}Sr_{0.5}) Si_{0.56}ON_{0.75}: 0.075Eu²⁺, 0.04Cl⁻] prepared according to Example of the present invention.

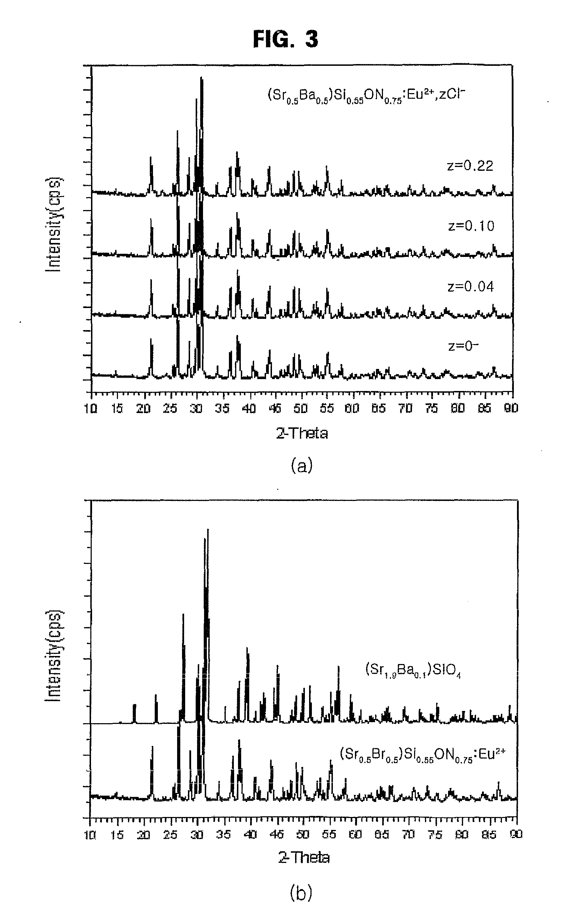

(a) of Fig. 3 is XRD graph of a phosphor [(Ba_{0.5}Sr_{0.5})Si_{0.56}ON_{0.75}:0.075Eu²⁺, zCl⁻] prepared according to Example of the present invention and (b) is a graph showing a comparison result with XRD pattern of (Sr_{1.9}Ba_{0.1})SiO₄ (ICSD #36042).

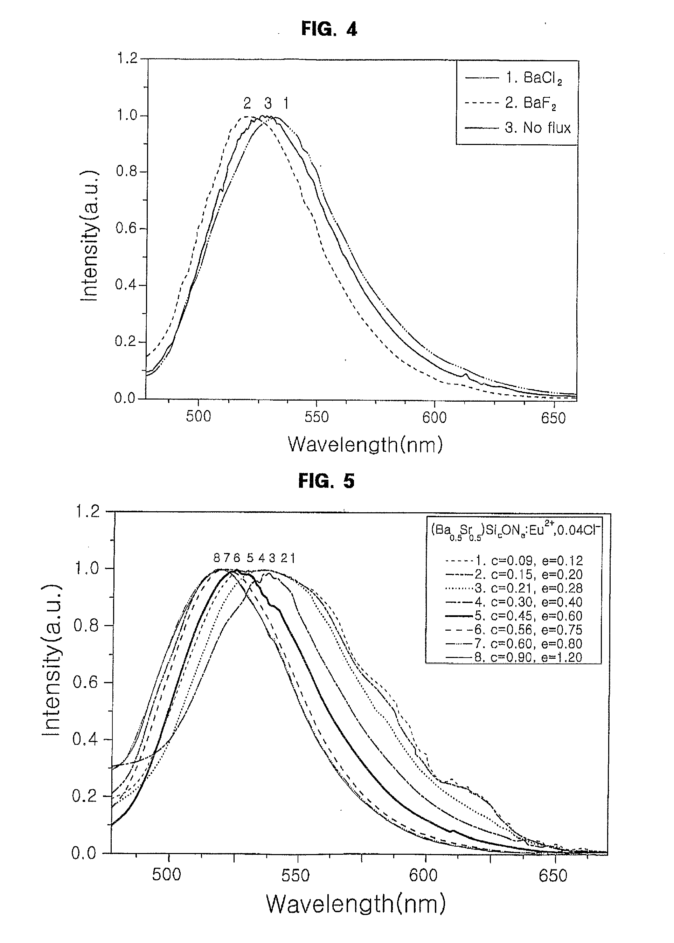

Fig. 4 is a graph showing the results of luminescence spectra according to a type of fluxs (Q) of a phosphor [(Ba_{0.5}Sr_{0.5}) Si_{0.56}ON_{0.75}: 0.075Eu²⁺, 0.04Q⁻] prepared according to Example of the present invention.

Fig. 5 is a graph showing the results of luminescence spectra according to a component ratio of Si and N of a phosphor [(Ba_{0.5}Sr₀.₅) Si_{c}ONe: 0.075Eu²⁺, 0.04Cl⁻] prepared according to Example of the present invention.

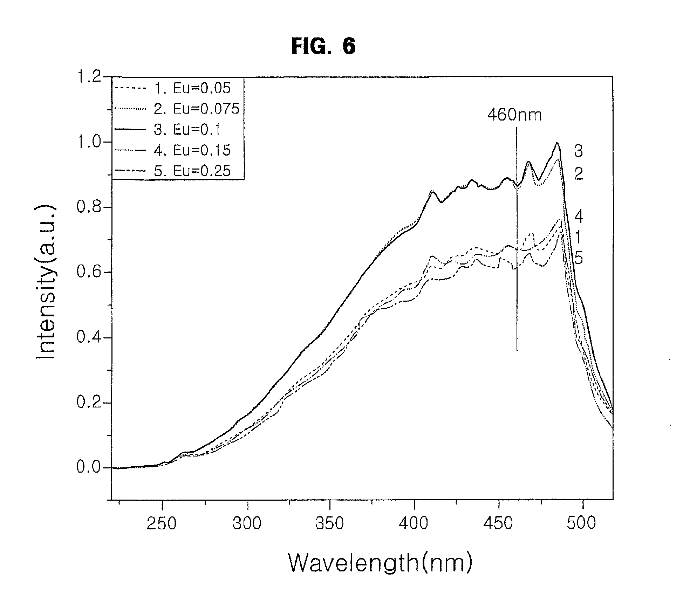

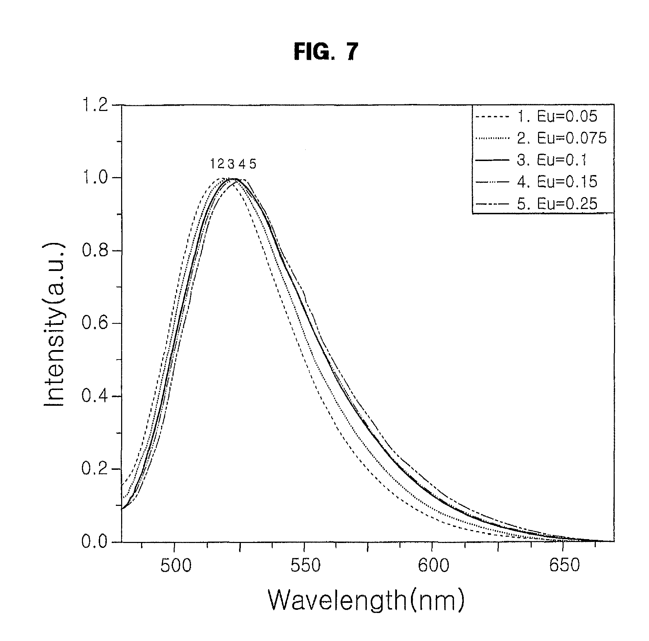

Figs. 6 and 7 are graphs showing the results of luminescence relative intensity and excitation spectra according to Eu²⁺ concentration of a phosphor [(Ba_{0.5}Sr_{0.5}) Si_{0.56}ON_{0.75}: 0.075Eu²⁺ 0.04Cl⁻] prepared according to Example of the present invention.

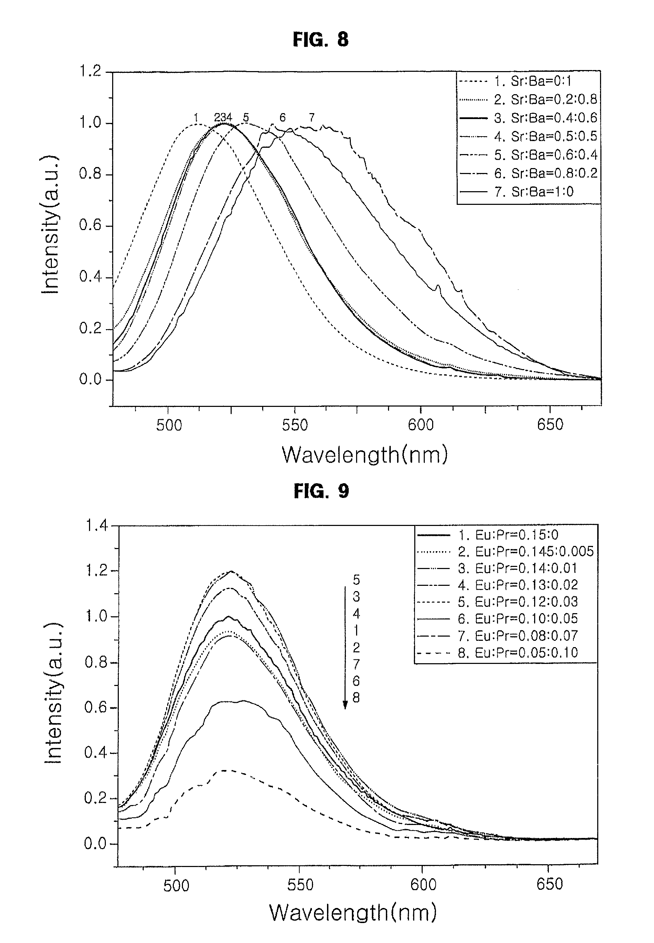

Fig. 8 is a graph showing the results of luminescence spectra according to a component ratio of Ba and Sr of a phosphor [(Ba_{0.5}Sr_{0.5}) Si_{0.56}ON_{0.75}: 0.075Eu²⁺, 0.04Cl⁻] prepared according to Example of the present invention.

Fig. 9 is a graph showing luminescence relative intensity according to a component ratio of Eu and Pr of a phosphor [(Ba_{0.5}Sr_{0.5}) Si_{0.56}ON_{0.75}: 0.075Eu²⁺, yRe³⁺, 0.04Cl⁻ (Re=Pr)] prepared according to Example of the present invention.

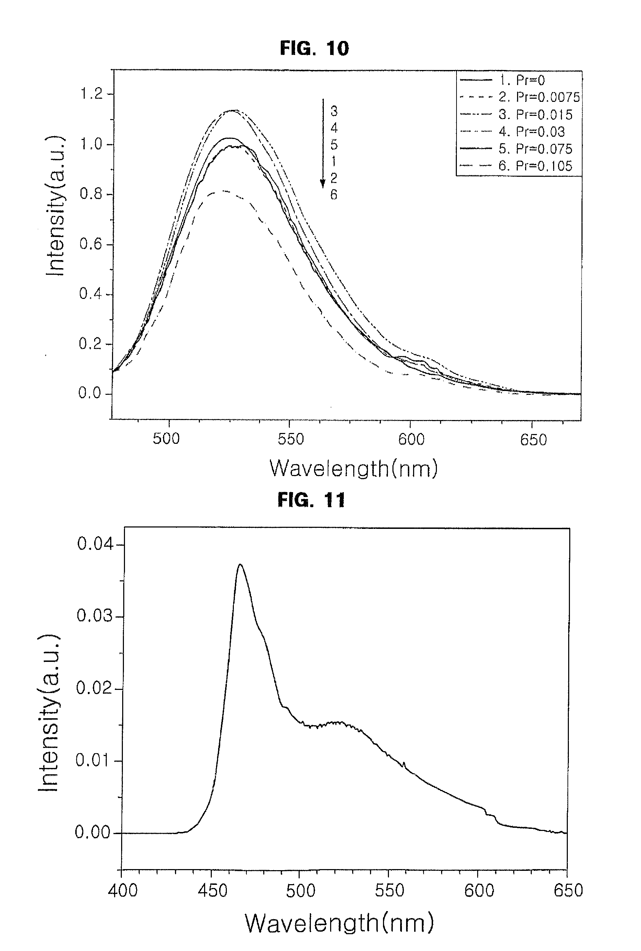

Fig. 10 is a graph showing luminescence relative intensity according to a component ratio of Pr at Eu fixed state of a phosphor [(Ba_{0.5}Sr_{0.5}) Si_{0.56}ON_{0.75}: 0.075Eu²⁺, yRe³⁺, 0.04Cl⁻ (Re=Pr)] prepared according to Example of the present invention.

Fig. 11 is a graph showing light-emitting spectra results of a white light-emitting device applied with a green phosphor according to Example of the present invention.

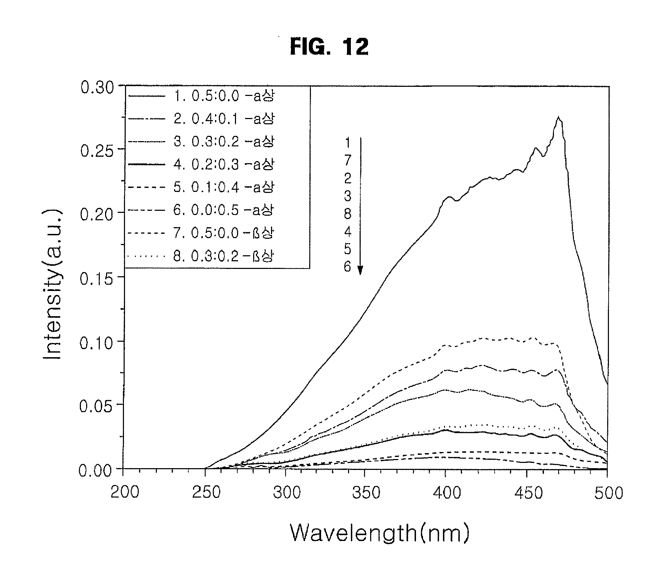

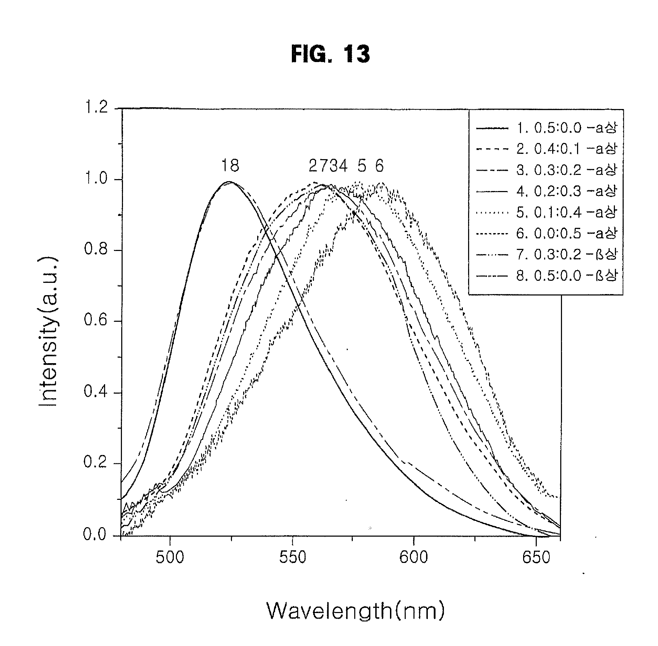

Figs. 12 and 13 are graphs showing the results of luminescence and excitation spectra according to a component ratio of Ba and Ca of a phosphor [(Sr_{(1-p-q}) BaₚCa_{q})Si_{0.56}ON₀.₇₅:0.075Eu²⁺, 0.04Cl⁻] prepared according to Example of the present invention.

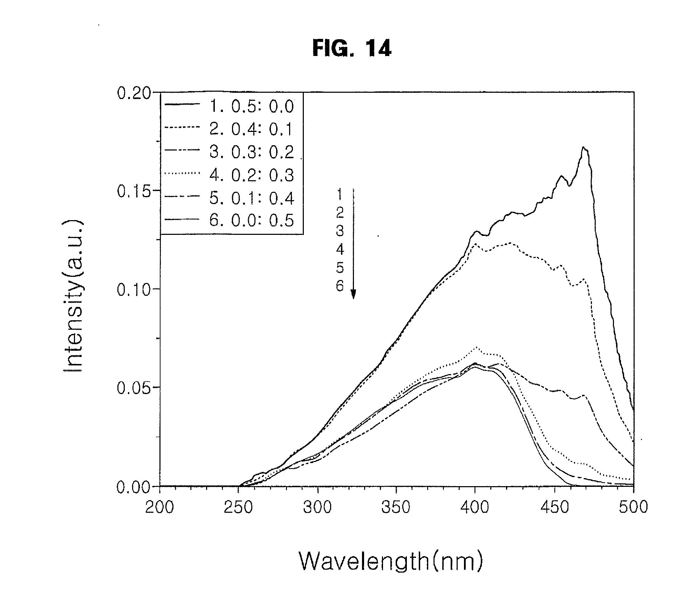

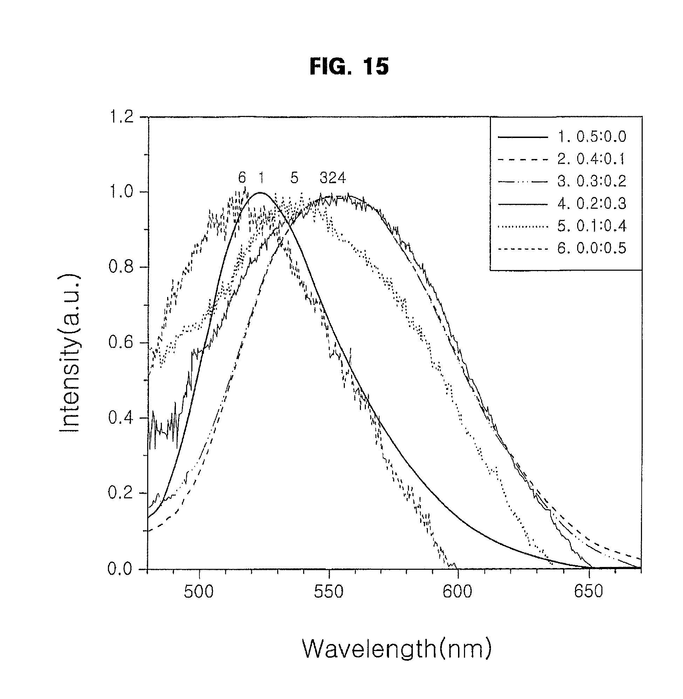

Figs. 14 and 15 are graphs showing the results of luminescence and excitation spectra according to a component ratio of Sr and Ca of a phosphor [(Ba_{(1-p-q}) SrpCa_{q}) Si_{0.56}ON_{0.75}:0.075Eu²⁺, 0.04Cl⁻] prepared according to Example of the present invention.

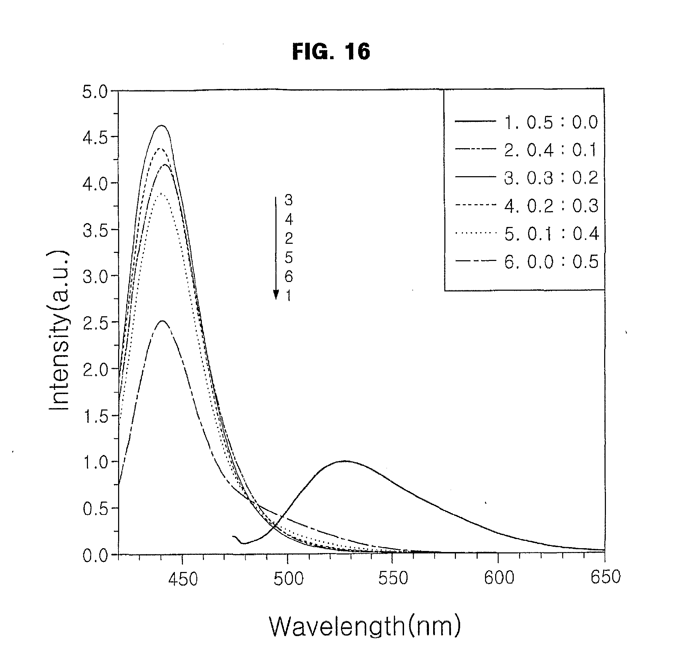

Fig. 16 is a graph showing luminescence relative intensity according to a component ratio of Sr and Mg of a phosphor [ (Ba_{(1-p-q)}SrₚMg_{q}) Si_{0.56}ON0_{.75}: 0.075Eu²⁺, 0.04Cl⁻] prepared according to Example of the present invention.

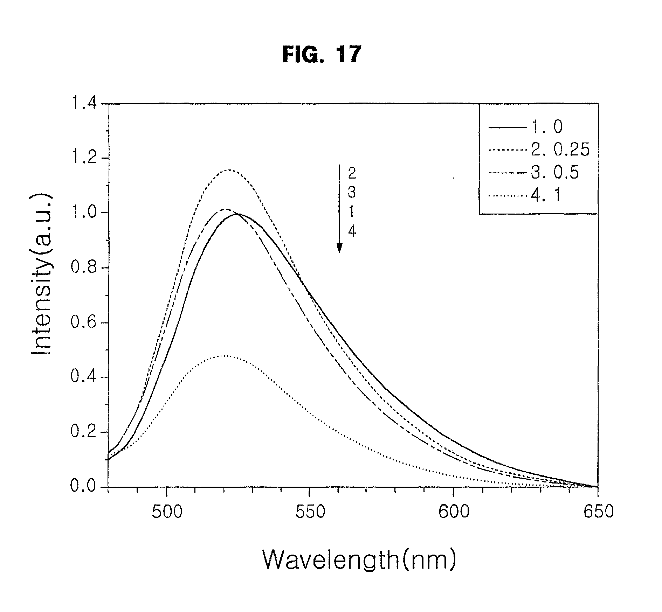

Fig. 17 is a graph showing luminescence relative intensity according to a component ratio of B of a phosphor [(Ba_{0.5}Sr_{0.5})B_{b}Si_{0.56}ON_{0.75}: 0.075Eu²⁺, 0.04Cl⁻] prepared according to Example of the present invention.

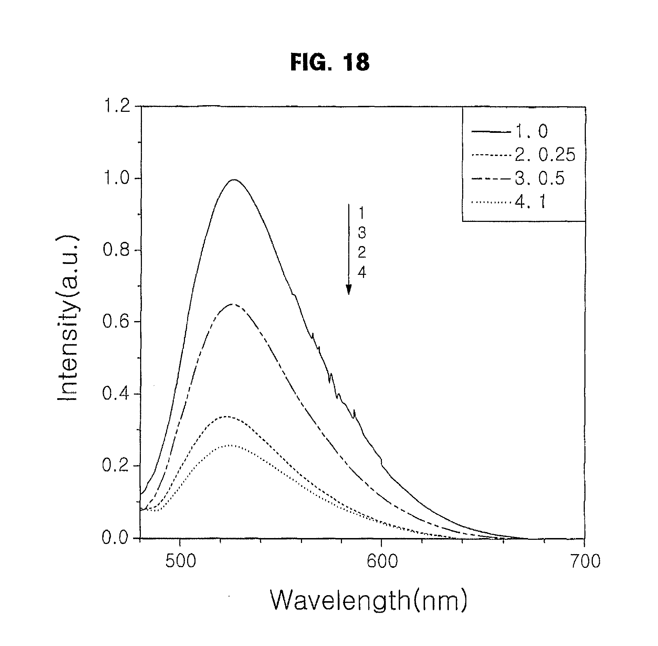

Fig. 18 is a graph showing luminescence relative intensity according to a component ratio of Al of a phosphor [(Ba_{0.5}Sr_{0.5}) Al_{b}Si_{0.56}ON_{0.75}: 0.075Eu²⁺, 0.04Cl⁻] prepared according to Example of the present invention.

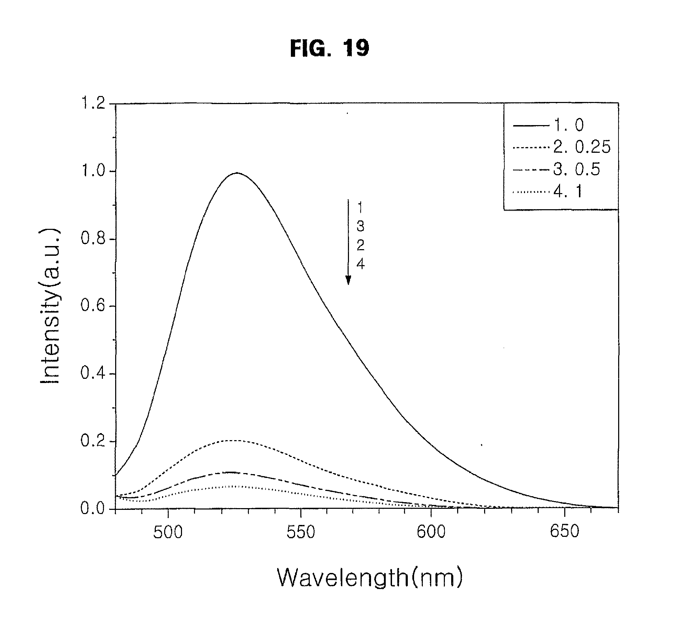

Fig. 19 is a graph showing luminescence relative intensity according to a component ratio of Ga of a phosphor [(Ba_{0.5}Sr_{0.5}) Ga_{b}Si_{0.56}ON_{0.75}: 0.075Eu²⁺, 0.04Cl⁻] prepared according to Example of the present invention.

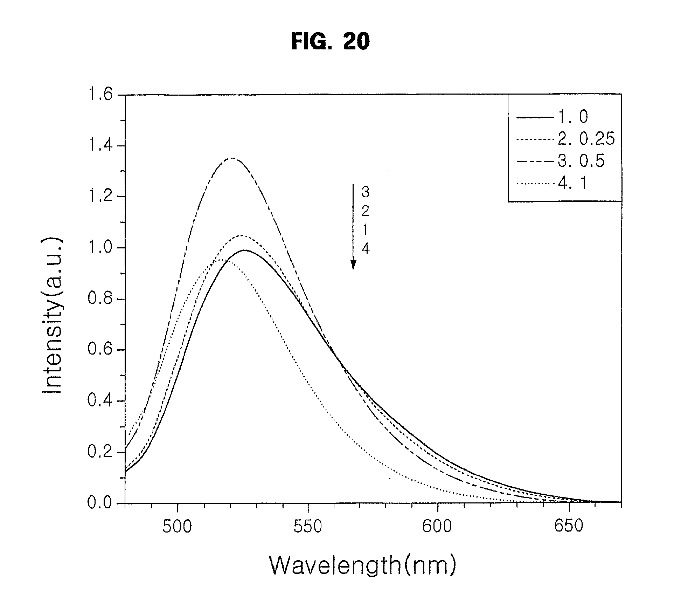

Fig. 20 is a graph showing luminescence relative intensity according to a component ratio of La of a phosphor [(Ba_{0.5}Sr_{0.5}) La_{b}Si_{0.56}ON_{0.75}: 0.075Eu²⁺, 0.04Cl⁻] prepared according to Example of the present invention.

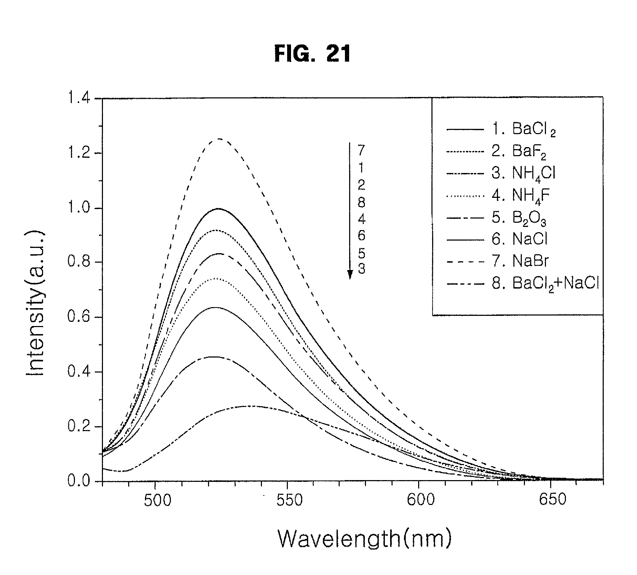

Fig. 21 is a graph showing luminescence relative intensity according to a type of Q of a phosphor [(Ba_{0.5}Sr_{0.5}) Si_{0.56}ON_{0.75}: 0.075Eu²⁺, 0.04Q] prepared according to Example of the present invention.

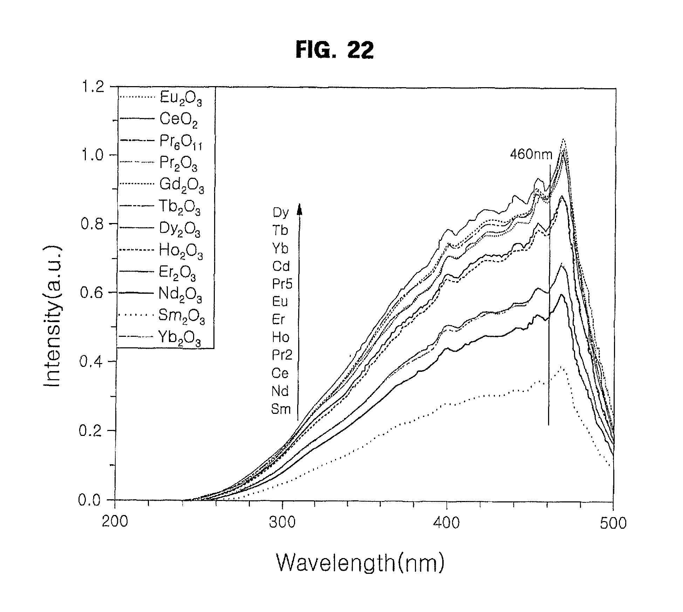

Fig. 22 is a graph showing luminescence relative intensity according to a type of Re of a phosphor [(Ba_{0.5}Sr_{0.5}) Si_{0.56}ON_{0.75}: 0.075Eu²⁺, 0.045Re³⁺, 0.04Cl⁻] prepared according to Example of the present invention.

### DESCRIPTION OF SPECIFIC EMBODIMENTS

Hereinafter, the present invention will be described in detail.

An oxynitride phosphor according to the present invention includes crystals represented by the following Chemical Formula:

[Chemical Formula] (A₍₁₋p-_{q)} BₚC_{q}) ₐD_{b}Si_{c}O_{d}Nₑ: xEu²⁺, yRe³⁺, zQ

[In the above Chemical Formula,

A, B, and C are +2 metals, but different metals from one another; D is elements of Group 3; Re is +3 metals; and Q is a flux]

At this time, each of the elements that consists the above Chemical Formula has specific components. Specifically, in the above Chemical Formula, p and q are contented with 0 < p < 1.0 and 0 ≤ q < 1.0, respectively. At this time, in the case of q > 0, p + q < 1. In addition, a, b, c, d, and e in the above Chemical Formula are contented with 1.0 ≤ a ≤ 2.0, 0 ≤ b ≤ 4.0, 0 < c ≤ 1.0, 0 < d ≤ 1.0, and 0 < e ≤ 2.0, respectively, and x, y, and z are contented with 0 < x ≤ 0.25, 0 ≤ y ≤ 0.25, and 0 ≤ z ≤ 0.25, respectively.

For the above Chemical Formula, when A is +2 metals, A is not limited. For example, for the above Chemical Formula, A may be more than one selected from the group consisting of Be, Mg, Ca, Sr, Ba, Ra, Zn, Cd, Hg, Pb, Sn, Ge, and the like.

In addition, for the above Chemical Formula, when B is +2 metals, but different kinds from types of A and C, B is not limited. For example, for the above Chemical Formula, B may be more than one selected from the group consisting of Be, Mg, Ca, Sr, Ba, Ra, Zn, Cd, Hg, Pb, Sn, Ge, and the like. At this time, according to a preferable embodiment, a component ratio of B, that is, p in the above Chemical Formula is preferably contented with 0.2 ≤ p ≤ 0.5. If p is contented with the same (in the case of 0.2 ≤ p ≤ 0.5), it has an excellent luminescence property, i.e., an excellent light-emitting luminance, and the like. In addition, if the component (p value) of B is largely increased so that the converted amount of B to A is too high; a red-shift may be occurred. For this reason, considering the luminescence property and red-shift, p (B component ratio) in the above Chemical Formula is preferably contented with 0.2 ≤ p ≤ 0.5.

For the above Chemical Formula, when C is +2 metals, but different kinds from types of A and B, C is not limited. For example, C in the above Chemical Formula may be more than one selected from the group consisting of Be, Mg, Ca, Sr, Ba, Ra, Zn, Cd, Hg, Pb, Sn, Ge, and the like. At this time, a component ratio of above C, that is, q in the above Chemical Formula is preferably contented with 0.1 ≤ q ≤ 0.5. If q is contented with the same (in the case of 0.1 ≤ q ≤ 0.5), the luminescence property can be improved but may be depended on a type of metals.

According to a preferable embodiment of the present invention, A and B in the above Chemical Formula is selected from the group consisting of Be, Ca, Sr, Ba, Ra, Zn, Cd, Hg, Pb, Sn, Ge, and the like; the C is Mg; and a component ratio q of the C is preferably contented with 0 < q < 0.6 (more preferably 0.1 ≤ q ≤ 0.5). In addition, according to other embodiment of the present invention, A in the above Chemical Formula is more than one selected from the group consisting of Be, Ca, Sr, Ba, Ra, Zn, Cd, Hg, Pb, Sn, Ge, and the like; B is Mg; p and q in the above Chemical Formula are preferably contented with 0 < p < 0.6 (more preferably, 0.1 ≤ p ≤ 0.5) and q = 0, respectively. When contenting with the same, it has an excellent luminescence property.

In addition, when D in the above Chemical Formula is elements of Group 3, D is not limited. For example, D in the above Chemical Formula is +3 metals or nonmetallic element, and may be selected from elements, such as Group 3A, Group 3B, and the like. More specifically, for example, D may be more than one selected from the group consisting of B, Al, Ga, In, Ti, Sc, Y, La, Ce, Pr, Nd, Pm, Sm, Gd, Tb, Dy, Ho, Er, Tm, Yb, Lu, and the like. At this time, the component ratio (mole ratio) of D to [(A_{(1-p-q)}BₚC_{q})ₐ], that is, b of the above Chemical Formula is preferably contented with 0 < b ≤ 1.0. Moreover, in the case of 0 < b ≤ 1.0, the D is not limited, but is preferably selected from the group consisting of B, La, and the like.

Meanwhile, the component ratio (mole ratio) of Si to [(A_{(1-p-q)}BₚC_{q})ₐ] in the above Chemical Formula, that is, c in the above Chemical Formula is preferably contented with 0.3 ≤ c ≤ 0.9. When increasing the component of Si too much, a blue-shift may be occurred. When the component of Si is contented with 0.3 ≤ b ≤ 0.9, the blue-shift can be prevented, and also an excellent luminescence property can be obtained. The component ratio of Si, that is, c in the above Chemical Formula is more preferably contented with 0.4 ≤ c ≤ 0.6. Moreover, the component ratio (mole ratio) of N to [(A_{(1-p-q)}BpC_{q})ₐ], that is, e in the above Chemical Formula is preferably contented with 0.4 ≤ e ≤ 1.2. More preferably, e in the above Chemical Formula is preferably contented with 0.5 ≤ e ≤ 1.0.

Eu in the above Chemical Formula is contained as an activator, and is made in less than 0.25 mole ratio to a host material [(A_{(1-p-q)}BₚC_{q})ₐD_{b}SicO_{d}Nₑ]. At this time, the component ratio of Eu, that is, x in the above Chemical Formula is preferably contented with 0.025 ≤ x ≤ 0.12, and more preferably, 0.075 ≤ x ≤ 0.12. When x is contented with the same (preferably 0.025 ≤ x ≤ 0.12, more preferably 0.075 ≤ x ≤ 0.12), the excellent luminescence is obtained.

In addition, Re in the above Chemical Formula plays a role as an auxiliary for improving the luminescence property, and when Re is +3 metals, Re is not limited. For example, the Re may be more than one selected from +3 rare earth metals (preferably lanthanoid metals). More specifically, for example, Re in the above Chemical Formula is preferably selected from the group consisting of La, Ce, Pr, Nd, Pm, Sm, Gd, Tb, Dy, Ho, Er, Tm, Yb, Lu, and the like. At this time, the component ratio (mole ratio) of Re to the host material [(A_{(1-p-q)}BₚC_{q}) ₐD_{b}Si_{c}O_{d}Nₑ], that is, y in Chemical Formula is preferably contented with 0.0075 ≤ y ≤ 0.1. y in the above Chemical Formula is more preferably contented with 0.0075 ≤ y ≤ 0.075, and most preferably 0.015 ≤ y ≤ 0.045.

Q in the above Chemical Formula is the flux, and selected from anion or cation, and if it can improve crystallizability, its type is not limited. For example, Q that is the flux may be selected from elements of halogen Group (Anion), such as F, Cl, Br, I, At, and the like and metal elements (Cation), such as B, Al, Ga, In, Ti, and the like. Q that is the flux is preferably anion, and more preferably selected from the elements of halogen Group (Anion). More specifically, Q in the above Chemical Formula is represented by X-, and the X is more preferably more than one selected from the group consisting of F, Cl, Br, and the like. According to the present invention, when adding the elements (X) of halogen Group as flux Q, while the crystals of phosphor become more stable, the luminescence property can be improved, and also the desired wavelength change can be induced (Wavelength Range Control).

At this time, when the concentration of flux Q is too high, it may be inconvenience because the calcinations temperature should be decreased due to the melting phenomenon of phosphor. Specifically, when the component ratio (mole ratio) of Q to the host material [(A_{(1-p-q}) BₚC_{q})ₐD_{b}Si_{c}O_{d}Nₑ], that is, z in the above Chemical Formula exceeds 0.25, the melting phenomenon of phosphor can be occurred. The phenomenon can be generated in the case of using the elements of halogen Group (X) as flux Q. Accordingly, when z in the above Chemical Formula is contented with 0 ≤ z ≤ 0.25, even though the calcinations temperature is high, the melting phenomenon is not occurred so that the temperature on calcining is freely settled and also the luminescence property is favorably improved. Preferably, the component ratio (z) of the Q is preferably contented with 0.02 ≤ z ≤ 0.15, more preferably contented with 0.02 ≤ z ≤ 0.04. When z is contented with the same (preferably 0.02 ≤ z ≤ 0.15, more preferably 0.02 ≤ z ≤ 0.04), the stability of crystals and also excellent luminescence property can be obtained. In addition, according to the preferable embodiment of the present invention, when x, y, and z in the above Chemical Formula are contented with 0.025 ≤ x ≤ 0.12, 0.0075 ≤ y ≤ 0.1, and 0.02 ≤ z ≤ 0.15 at the same time, the stability of crystals and luminescence property are more favorably improved.

According to the present invention, the phosphor has the excellent light-emitting efficiency by including the crystals represented by the above Chemical Formula. Specifically, the phosphor according to the present invention is represented by the above Chemical Formula, but should contains the crystals that are contented with the component ratio (mole ratio) and conditional expression as mentioned above thereby emitting light by exciting by light source (Light, Electromagnetic Waves, such as X-rays, Electron Ray, Heat, and the like) in the various wavelength range, and having the excellent luminescence intensity (Light-emitting luminance).

The phosphor according to the present invention at least includes the crystals of the above Chemical Formula, but preferably further includes others fluorescence material. In addition, the phosphor according to the present invention, that is, the crystals represented by Chemical Formula may have the size (Particle Size) from hundreds manometer (nm) to dozens micrometer (µm), but not limited thereto, and preferably may have the size of 1 - 30 µm.

In addition, the phosphor according to the present invention, that is, the crystals represented by the above Chemical Formula have the excellent light-emitting property in a wavelength range of a bluish green scope, for example, the bluish green scope of 510~540 nm wavelength range. That is, the preferable light-emitting wavelength (Luminescence Wavelength Range) of the phosphor according to the present invention is for example 510 - 540 nm. As mentioned above, the phosphor according to the present invention has the excellent light-emitting property especially in the bluish green scope (such as, 510 - 540 nm wavelength range) so that it can be usefully applied as the bluish green phosphor of 3-wavelength white light device.

Meanwhile, a method for preparing the phosphor according to the present invention is a method for preparing the phosphor having the above components at a low price, and at least includes the following two steps:

(1) mixing raw materials including A precursor, B precursor, C precursor, D precursor, Si precursor, N precursor, Eu precursor, Re precursor, and Q precursor (First Step); and

(2) calcining the raw materials by injecting the raw materials to a calcinations furnace (Second Step).

At this time, in the first step(Step for Mixing), the contents (mole ratio) of each of raw materials (precursors) are controlled and then mixed to be contented with the above Chemical Formula (Component ratio and Conditional Expression). Specifically, the contents (mole ratio) of each of raw materials (precursors) are controlled and then made so that p and q in the above Chemical Formula are contented with 0 < p < 1.0 and 0 ≤ q < 1.0, respectively; the a, b, c, d, and e are contented with 1.0 ≤ a ≤ 2.0, 0 ≤ b ≤ 4.0, 0 < c ≤ 1.0, 0 < d ≤ 1.0, and 0 < e ≤ 2.0, respectively; and the x, y, and z are contented with 0 < x ≤ 0.25, 0 ≤ y ≤ 0.25, and 0 ≤ z ≤ 0.25. For example, Si precursor is mixed in a proper weight to be 0 < Si mole number ≤ 1.0(0 < c ≤ 1.0) based on 1.0 mole to 2.0 mole (1.0 ≤ a ≤ 2.0) of [(A_{(1-p-q)}BₚC_{q})]. In addition, as other example, Eu precursor is mixed in a proper weight to be 0 < Eu mole number ≤ 0.25 (0 < x ≤ 0.25) based on 1.0 mole of [(A _{(1-p-q)} BₚC_{q}) ₐD_{b}SicO_{d}Nₑ].

In addition, in the first step (Step for Mixing), it can be performed that each of raw materials (precursors) are mixed and grinded through a ball mill, Ultrasonic waves, and the like.

In addition, in the second step (Step for Calcining), it is preferably performed by using the method for calcining, comprising the temperature of the calcinations furnace is increased to 800°C - 1300°C while injecting an ammonia gas (NH₃ gas) inside the calcinations furnaces in 5 - 15 mL/min, and then is maintained at the temperature of 800°C ∼ 1300°C for 2∼5 hours while continuously injecting the ammonia gas inside the calcinations furnace.

Salts, oxides, nitrides, and the like of each of elements can be used as the precursors of each of the raw materials, that is, the precursors of A, B, C, D, Si, N, Eu, Re, and Q. For example, in the case of the metal precursor, metallic salts, metallic oxides, metallic nitrides, and the like can be used.

More specifically, more than one selected from the group consisting of the compounds of Be, Mg, Ca, Sr, Ba, Ra, Zn, Cd, Hg, Pb, Sn, and Ge (Salts, Oxides, Nitrides, and the like) can be used as the metal precursor, that is, A precursor (A is +2 metals), B precursor (B is +2 metals, but different metals from A), and C precursor (C is different metals from A and B, that is, +2 metals). At this time, the precursors of A, B, and C are selected from different compounds each other. For example, when A (B or C) is Ba, it is specifically not limited, Ba precursor may use more than one selected from the group consisting of the compounds containing Ba, such as, Ba salt (For example, BaCO₃, BaSO₄, and the like), Ba oxide (BaO), Ba nitride (Ba₃N₂), and the like. As other example, Ca precursor may use more than one selected from the group consisting of CaO, CaCO₃, Ca₃N₂, and the like.

In addition, the D precursor (D is elements of Group 3) may use more than one selected from the group consisting of the compound containing elements, such as Group 3A, Group 3B, and the like, for example, the compound (Salts, Oxides, Nitrides, and the like) of B, Al, Ga, In, Ti, Sc, Y, La, Ce, Pr, Nd, Pm, Sm, Gd, Tb, Dy, Ho, Er, Tm, Yb, and Lu. More specifically, for example, D precursor may use more than one selected from the group consisting of BN, AlN, LaN, GaN, B₂O₃, Al₂O₃, La₂O₃, Ga₂O₃, and the like.

In addition, Si precursor may be selected from Si salt, Si oxide, Si nitride, and the like. Preferably, Si precursor may usefully use Si nitride, for example Si₃N₄, and the like in order to supply nitrogen in the raw materials. In addition, the N precursor may use nitride, for example, BN, AlN, LaN, GaN, Si₃N₄, Ca₃N₂, and the like, but the N precursor may be not added when using Si nitride (Si₃N₄, and the like) as Si precursor. In addition, oxygen (O) included in the crystals of the above Chemical Formula may be included in the components because of using the metallic oxide (Oxide of metal A) as any one precursor (for example, A precursor).

In addition, for example, the Eu precursor may use more than one selected from Eu₂O₃, Eu₂ (C₂O₄)₃, and the like. In addition, the Re precursor may use more than one selected from the group consisting of for example, the compound (salts, oxides, nitrides, and the like) of La, Ce, Pr, Nd, Pm, Sm, Gd, Tb, Dy, Ho, Er, Tm, Yb, and Lu. As more specific example, Re precursor may use more than one selected from the group consisting of La₂O₃, CeO₂, Pr₆O₁₁, Pr₂O₃, Gd₂O₃, Tb₄O₇, DY₂O₃, Ho₂O₃, Er₂O₃, Nd₂O₃, Sm₂O₃, Yb₂O₃, and the like.

In addition, the Q precursor (Flux Precursor) may be selected from salts of halogen Group (X precursor), metallic/nonmetallic compound, and the like. For example, Q precursor may be selected from the salts of halogen Group, such as BaX₂, NH₄X, and NaX (X is F, Cl, Br, I, At, and the like), or the metallic/nonmetallic compound, such as, B₂O₃, Al₂O₃, Ga₂O₃, and the like. The Q precursor is preferably selected from the salts of halogen Group.

According to the preparing method of the present invention as mentioned above, the cost for preparing is low by selecting from the precursors (Metallic Salts), in which for the precursors, the cost for getting the starting raw materials of the phosphor is lower than that of the conventional nitride. And also, the synthesize (Calcinations) can be possible at low temperature and atmospheric pressure by selecting the starting raw materials from the precursors, such as the metallic salts as mentioned above. Specifically, in the second step (Step for Calcining), the calcinations can be possible at low temperature of 800 °C ∼ 1300 °C (preferably, less than 1000°C) under the atmospheric pressure. Accordingly, according to the present invention, the phosphor can be supplied at a low price because the cost for preparing the phosphor can be decreased due to the purchase of raw materials with a low price, energy saving, and the like.

Meanwhile, the light-emitting device according to the present invention includes the oxynitride phosphor of the present invention as mentioned above as the wavelength conversion material. Specifically, the light-emitting device according to the present invention includes the excitation light source; and a phosphor, but the phosphor at least includes the oxynitride phosphor of the present invention as mentioned above.

The excitation light source may be selected from the light source emitting (light emitting) for example, the blue light, and the like. As more specific example, the excitation light source may be selected from Light-Emitting Diode (LED), Organic Light-Emitting Diode (OLED), Laser Diode (LD), and other light source emitting (light-emitting) the blue light. At this time, the light-emitting wavelength of the excitation light source may be 350 nm ∼ 480 nm, but not limited thereto. Specifically, the excitation light source may be selected from Light-Emitting Diode (LED), Organic Light-Emitting Diode (OLED), Laser Diode (LD), and the like, that emit (Light-emit) light (such as, the blue light)in the wavelength range from 350 nm to 480 nm. In addition, the light-emitting device according to the present invention can implement light of white color by the excitation light source and the phosphor.

In addition, the phosphor is mixed with a binder, and then molded on the excitation light source, but the phosphor may be used in 0.1∼30 wt%, but is not limited thereto. That is, the phosphor may be included in 0.1∼30 wt% based on the total weight of molding composition containing the phosphor and the binder. At this time, the binder can be used if it has an adhesive property, and for example, can use a polymer, such as epoxy resin, silicon resin, urethane resin, acryl resin, and the like, but not limited thereto.

Hereinafter, Examples according to the present invention will be indicated. The following Examples are only provided for helping the understanding of the present invention, but do not limit to the technical range of the present invention.

According to the present invention, the oxynitride phosphor has an excellent light-emitting efficiency (Light-Emitting Luminance, and the like) by including crystals represented by Chemical Formula having the above components. And, the crystals represented by the above Chemical Formula are stable. In addition, according to the present invention, the oxynitride phosphor can be provided at a low price since precursors, such as metallic salts, and the like are used as starting raw materials so that it can be synthesized and calcinated at atmospheric pressure and low temperature.

While the present invention has been described with respect to the specific embodiments, it will be apparent to those skilled in the art that various changes and modifications may be made without departing from the spirit and scope of the invention as defined in the following claims.

[Example 1]

Preparation of Phosphor having Components of [(Ba_{0.5}Sr_{0.5}) Si_{0.56}ON_{0.75}: 0.075Eu²⁺, 0.04Cl⁻

Firstly, raw materials were mixed and made in the contents (Mole Number) and the components as shown in the following [Table 1]. Next, the mixed raw materials were added to a calcinations furnace (Melting Pot) and then the temperature in the calcinations furnace was increased to 900 °C in the increasing rate of 10 °C/min while an ammonia gas (NH₃ gas) was injected in 10 mL/min. And then, the temperature in the calcination furnace was maintained at 900 °C for 3 hours while continuously injecting the ammonia gas (NH₃ gas) to obtain crystals (Phosphor) according to the present Example. As shown in the following [Table 1], a halogen precursor (BaCl₂) as a flux was added to be 2 wt% BaCl₂ solution based on the total weight of raw materials, and then as the rest raw materials, powders having a particle size of 2-4 µm were used. The mole numbers of each of raw materials were shown in the following [Table 1].

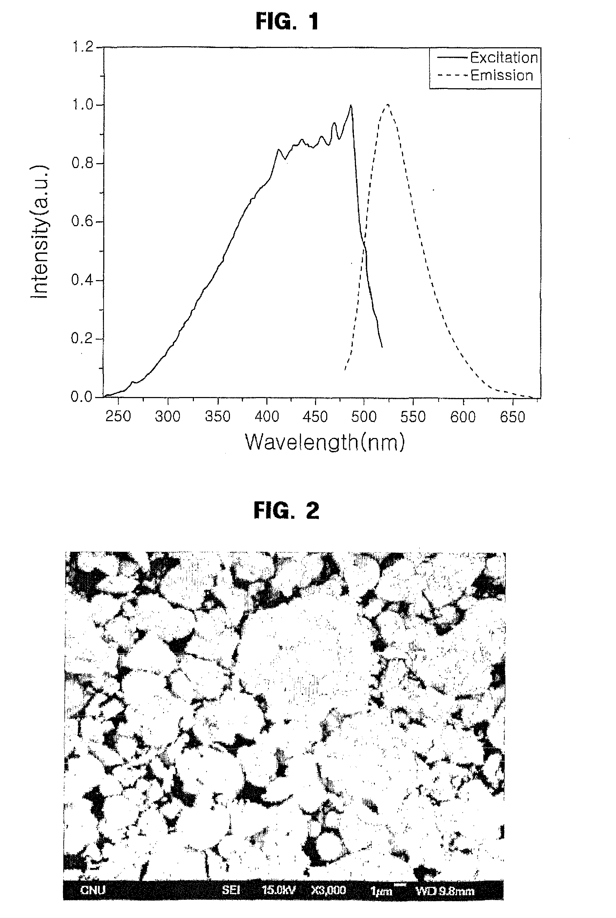

The phosphor (Crystals) prepared according to the present Examples had the components of Chemical Formula, (Ba_{0.5}Sr_{0.5}) Si_{0.56}ON_{0.75}: 0.075Eu²⁺, 0.04Cl⁻. Luminescence and excitation spectra about the prepared phosphor were evaluated, and then the results thereof were shown in the enclosed Fig. 1. As shown in Fig. 1, a luminescence peak having largest intensity was appeared at approximately λₑₓₙ = 460 nm, and emitted light at approximately λₑₘₛ = 525 nm. The enclosed Fig. 2 is SEM image of phosphor crystals prepared according to the present Example. As shown in Fig. 2, the phosphor crystals had a particle size of 1 - 10 µm range, and the above particle size is relevant to a proper size as a phosphor.

**[Table 1]**

| <Components of Raw Materials> | | | |
|---|---|---|---|
| Component | Content (Based on Solid) | mol | MW |
| BaCO₃ | 0.3947g | 2 mmol | 197.34 |
| SrCO₃ | 0.2953g | 2 mmol | 147.21 |
| Si₃N₄ | 0.1053g | 0.75 mmol | 140.29 |
| BaCl₂(flux) | 0.0173g | 0.08 mmol | 208.25 |
| Eu₂O₃ | 0.0528g | 0.15 mmol | 351.93 |

[Example 2]

Preparation of Phosphor having Components of (Ba_{0.5}Sro_{0.5}) Si₀.₅₆ON_{0.75}: 0.075Eu²⁺

Compared to the Example 1, the method disclosed in Example 1 was used except for not using the halogen precursor (BaCl₂) as a flux. The components of the raw materials according to the present Example were shown in the following [Table 2].

**[Table 2]**

| <Components of Raw Materials> | | | |
|---|---|---|---|
| Component | Content (Based on Solid) | mol | MW |
| BaCO₃ | 0.3947g | 2 mmol | 197.34 |
| SrCO3 | 0.2953g | 2 mmol | 147.21 |
| Si₃N₄ | 0.1053g | 0.75 mmol) | 140.29 |
| Eu₂O₃ | 0.0528g | 0.15 mmol | 351.93 |

The phosphor prepared according to the present Example had the components of Chemical Formula, (Ba_{0.5}Sr_{0.5}) Si_{0.56}ON_{0.75}: 0.075Eu²⁺.

[Examples 3 to 8]

Preparation of Phosphor of (Ba_{0.5}Sr_{0.5}) Si_{0.56}ON _{0.075}:0.075Eu ²⁺, zCl⁻ (Preparation of Phosphor according to Concentration of Q)

In order to confirm a luminescence intensity according to a concentration of Q (Component Ratio of Cl, z value) as a flux, it was performed by using the same method with the Example 1, but the different content of BaCl₂ (Flux) was used. Specifically, z value of the above Chemical Formula were changed as shown in the following [Table 3] by changing the contents of BaCl₂ (Flux) according to each of the Examples.

The phosphors prepared according to the present Examples 3 to 8 had the components of Chemical Forumla, (Ba_{0.5}Sr_{0.5}) Si_{0.56}ON_{0.75}: 0.075Eu²⁺, zCl⁻. The luminescence relative intensity was measured to the phosphors prepared according to each of the Examples, and then the results thereof were shown in the following [Table 3]. At this time, the relative intensity shown in the following [Table 3] was based on the Example 2 (Intensity=1), in which z is 0. And, Example 5 in the following [Table 3] used the same phosphor specimen with that of the Example 1.

**[Table 3]**

| <Luminescence Relative Intensity According to Cl Component Ratio(z Value)> | | | | | | | |
|---|---|---|---|---|---|---|---|
| Note | Example2 | Example3 | Example4 | Example5 | Example6 | Example7 | Example8 |
| BaCl₂ Content (mmol) | 0 | 0.02 | 0.04 | 0.08 | 0.20 | 0.30 | 0.44 |
| Component (z Value) | 0 | 0.01 | 0.02 | 0.04 | 0.10 | 0.15 | 0.22 |
| Relative intensity | 1 | 0.971 | 1.093 | 1.132 | 0.911 | 0.907 | 0.824 |

The elements of halogen Group (X) added as the flux contribute to the stability of crystals, but as shown in the above [Table 3], it could be known that when an excess elements of halogen Group (X) was used, the melting phenomenon was occurred thereby decreasing the light-emitting phenomenon. In addition, it could be known from the Examples that in the case of 0.02 ≤ z ≤ 0.15, the relative intensity was favorably above 0.9. Especially, it could be known that in the case of 0.02 ≤ z ≤ 0.04, the relative intensity was above 1 so that the luminescence intensity (Light-Emitting Efficiency) was very excellent. It could be also known that in the case of z = 0.04, it was highly valued.

Meanwhile, (a) of Fig. 3 shown XRD pattern of phosphors of (Ba_{0.5}Sr_{0.5}) Si_{0.56}ON_{0.75}: 0.075Eu²⁺, zCl⁻ prepared according to Examples 2, 5, 6, and 8. As shown in (a) of Fig. 3, even if the content of BaCl₂ was highly increased, 2θ values and intensities of measured peaks were not changed. It means that while the crystal structure and components of the phosphors were not changed within the range of BaCl₂ contents (0.44 mmole) up to the extent of Example 8, it acts as an auxiliary for improving the luminescence intensity.

In addition, (b) of Fig. 3 shown a comparison graph of XRD patterns between an oxynitride according to Example 2 of the present invention and the conventional oxide (Sr_{1.9}Ba_{0.1})SiO₄ (ICSD #36042). As shown in (b) of Fig. 3, it could be known that XRD pattern tendency of the phosphor according to Example 2 of the present invention was similar to XRD pattern of the conventional oxide (Sr_{1.9}Ba_{0.1})SiO₄, and only it could be known from 2θ value that a blue-shift was occurred to the extent of about 0.4-1.6. It could be predicted that the above results came from the change of the mole ratio of Ba and Sr and the substitution of some of O (Oxygen) with N (Nitrogen). And also, it could be known that the crystal structure of the oxynitride phosphor according to Example 2 of the present invention had a orthorhombic crystal structure that is similar to the conventional oxide (Nitrogen deficiency) phosphor (Sr₁.₉Ba_{0.1})SiO₄.

[Examples 9 to 11]

Preparation of Phosphor having (Ba_{0.5}Sr_{0.5}) Si_{0.56}ON_{0.75}: 0.075Eu²⁺, 0.04Q (Preparation of Phosphor According to A Type of Q)

In order to confirm the luminescence intensity according to a type of halogen precursor (Halogen Salt) (A type of Q) as the flux, the same method with the Example 1 was used except for using a different type of halogen salts (Q=Cl, F) as the following [Table 4] for making each of the raw materials. At this time, the content of the halogen salt was fixed at 0.08 mmol that was evaluated as the most preferable value to fix z=0.04.

The phosphors prepared according to the present Examples 9 to 11 had the components of Chemical Forumla, (Ba_{0.5}Sr_{0.5}) Si_{0.56}ON_{0.75}: 0.075Eu²⁺, 0.04Q⁻ (Q=Cl, F). The luminescence relative intensities about the phosphors prepared according to each of the Examples were measured and then the results thereof were shown in the following [Table 4]. At this time, the relative intensities shown in the following [Table 4] were based on the Example 1 (Intensity=1) using BaCl₂ as the halogen precursor. And, the relative intensity of the Example 2 not adding the halogen precursor (Based on Example 1) was shown along with the above results. In addition, the enclosed Fig. 4 shown the excitation (λₑₘₛ=525 nm) spectra at the same luminescence intensity (Based on 1.0) of the phosphors according to Example 1 (BaCl₂), Example 9 (BaF₂), and Example 2 (No flux).

**[Table 4]**

| < Luminescence Relative Intensity According to A Type of Q, z =0.04> | | | | | |
|---|---|---|---|---|---|
| Note | Example1 | Example9 | Example10 | Example11 | Example2 |
| A Type of Halogen Precursor | BaCl₂ | BaF₂ | NH₄Cl | NH₄F | Not Adding (No flux) |
| Relative Intensity | 1 | 0.727 | 0.716 | 0.909 | 0.688 |

As shown in the above [Table 4], it could be known that when using BaCl₂ (Example 1) and NH₄F (Example 11) as the halogen precursor, excellent results were evaluated, and BaCl₂ (Example 1) was most excellent. In addition, as shown in Fig. 4, it could be known that the wavelength change of about 5~8 nm was appeared according to whether or not Cl and F were presented.

Accordingly, it could be found from the present Examples that the luminescence intensity became larger when containing flux Q (Halogen Element) in the components. That is, the phosphors of Example 1, 9 to 11 had large luminescence intensity rather than that of Example 2 without flux Q (Halogen Element). In addition, as shown in Fig. 4, it could be found that the wavelength can be changed by adding Q (Halogen). Specifically, it could be found that the range of wavelength can be controlled by changing a type of Q (Halogen), or adding or not adding Q (Halogen).

[Examples 12 to 18]

Preparation of Phosphor of (Ba_{0.5}Sr_{0.5}) Si_{0.56}ON_{0.75}: 0.075Eu²⁺, 0.04Cl⁻ (Preparation of Phosphor According to Component Ratio of Si and N)

In order to confirm the luminescence intensity according to the component ratio (c value, e value) of Si and N, the same method with the Example 1 was used except for changing the content of Si₃N₄. Specifically, c value and e value of the above Chemical Formula were changed as shown in the following [Table 5] by changing the contents (mol) of Si₃N₄ according to each of the Examples.

The phosphors prepared according to the present Examples 12 to 18 had the components of Chemical Formula, (Ba_{0.5}Sr_{0.5}) SicONₑ: 0.075Eu²⁺, 0.04Cl⁻. The luminescence relative intensities (λₑₓₙ=460 nm) were measured about the phosphors prepared according to each of the Examples, and than the results thereof were shown in the following [Table 5]. At this time, the relative intensity shown in the following [Table 5] was c=0.45, and based on Example 16 (Intensity=1) that was e=0.6. And, the relative intensity of Example 1 that was c=0.56 and e=0.75 was also shown based on Example 16 (Intensity=1) in [Table 5]. In addition, the enclosed Fig. 5 shown the excitation (λₑₘₛ=525 nm) spectra of the phosphors according to each of the Examples (Component Ratio of Si and N).

**[Table 5]**

| <Luminescence Relative Intensity According to Si, N Component Ratio(c, e)> | | | | | | | | | |
|---|---|---|---|---|---|---|---|---|---|
| Note | | Example 12 | Example 13 | Example 14 | Example 15 | Example 16 | Example 1 | Example 17 | Example 18 |
| Si₃N₄ Content (mmol) | | 0.12 | 0.24 | 0.41 | 0.51 | 0.68 | 0.75 | 0.81 | 1.02 |
| Component | c | 0.09 | 0.15 | 0.21 | 0.3 | 0.45 | 0.56 | 0.6 | 0.9 |
| | e | 0.12 | 0.2 | 0.28 | 0.4 | 0.6 | 0.75 | 0.8 | 1.2 |
| Relative intensity | | 0.031 | 0.051 | 0.129 | 0.280 | 1 | 0.738 | 0.560 | 0.303 |

Firstly, as shown in the enclosed Fig. 5, it could be found that the blue-shift was occurred as the component of Si was increased. In addition, it could be found from the present Example that as shown in the above [Table 5], the component of Si (c value) to (Ba_{0.5}Sr_{0.5}) had a relatively good luminescence intensity at 0.3 ≤ c ≤ 0.9, and preferably, 0.45 ≤ c ≤ 0.56, and had the best property in the case of c=0.45. In addition, it could be found from the present Example that the component of N (e value) to (Ba_{0.5}Ssr_{0.5}) had a relatively good luminescence intensity at 0.4 ≤ e ≤ 1.2, and preferably, 0.6 ≤ e ≤ 0.75, and had the best property in the case of e=0.6.

[Examples 19 to 22]

Preparation of Phosphor of (Ba_{0.5}Sr_{0.5}) Si_{0.56}ON_{0.75}: 0.075Eu²⁺, 0.04Cl⁻ (Preparation of Phosphor According to Concentration of Eu²⁺)

In order to confirm the luminescence intensity according to the concentration of Eu²⁺ (Component Ratio, x value), the same method with the Example 1 was used except for changing the content of Eu₂O₃ for making the raw materials. Specifically, x value of the above Chemical Formula was changed as shown in the following [Table 6] by changing the content of Eu₂O₃ according to each of the Examples.

The phosphors prepared according to the present Examples 19 to 22 had the components of Chemical Formula, (Ba_{0.5}Sr_{0.5}) Si_{0.56}ON_{0.75}: 0.075Eu²⁺, 0.04Cl⁻. The luminescence relative intensities (λₑₓₙ=460 nm) were measured about the phosphors prepared according to each of the Examples, and than the results thereof were shown in the following [Table 6]. At this time, the relative intensity shown in the following [Table 6] was based on Example 1 (Intensity=1) that was x=0.075. In addition, the enclosed Figs. 6 and 7 shown the luminescence relative intensity (λₑₓₙ=460 nm) and excitation (λₑₘₛ=525 nm) spectra of the phosphors according to each of the Examples (Concentration of Eu²⁺).

**[Table 6]**

| <Luminescence Relative Intensity According to Eu²⁺ Component Ratio(x Value)> | | | | | |
|---|---|---|---|---|---|
| Note | Example 19 | Example 1 | Example20 | Example 21 | Example 22 |
| Eu₂O₃ Content Mole Ratio to (Ba_{0.5}Sr_{0.5}) | 0.025 | 0.0375 | 0.05 | 0.075 | 0.125 |
| Component (x) | 0.05 | 0.075 | 0.1 | 0.15 | 0.25 |
| Relative intensity | 0.8 | 1 | 1 | 0.7 | 0.8 |

As shown in the above [Table 6] and enclosed Fig. 6, it could be found that the component of Eu2⁺ to the host material [(Ba_{0.5}Sr_{0.5}) Si_{0.56}ON₀.₇₅] had an excellent luminescence intensity that was above 0.7 of relative intensity at x ≤ 0.25. And, it could be found from the present Examples that it had the excellent luminescence intensity in the case of 0.075 ≤ x ≤ 0.12, and had the best property in the case of x=0.075 and 0.1. In addition, as shown in Fig. 7, it could be found that the wavelength of the excitation spectra according to the concentration of Eu²⁺ (x value) was not changed.

[Examples 23 to 29]

(Ba₁₋ₚSrₚ) Si_{0.56}ON_{0.75}s: 0.075Eu²⁺, 0.04Cl⁻ (Preparation of Phosphor According to Component Ratio of Ba and Sr)

In order to confirm the luminescence intensity according to the component ratio (p value) of Ba and Sr, the same method with the Example 1 was used except for changing the contents of BaCO₃ and SrCO₃ for making the raw materials. Specifically, p values of the above Chemical Formula were changed as shown the following [Table 7] by changing the contents (mol) of BaCO₃ and SrCO₃ according to each of the Examples.

The phosphors prepared according to the present Examples 23 to 29 had the components of Chemical Formula, (Ba₁₋ₚSrₚ)Si_{0.56}ON_{0.75}:0.075Eu²⁺, 0.04Cl⁻_{.} The luminescence relative intensities (λₑₓₙ=460 nm) were measured to the phosphors prepared according to each of the Examples, and then the results thereof were shown in the following [Table 7]. At this time, the relative intensity shown in the following [Table 7] was based on Example 25 (Intensity=1) that was p=0.4. And, Example 25 in the following [Table 7] used the same phosphor specimen with the Example 1. In addition, the enclosed Fig. 8 shown the excitation (λₑₘₛ=520 nm) spectra of the phosphors according to each of the Examples (Component Ratio of Ba and Sr).

**[Table 7]**

| <Luminescence Relative Intensity According to Ba and Sr Component Ratio (p)> | | | | | | | |
|---|---|---|---|---|---|---|---|
| Note | Example 23 | Example 24 | Example 25 | Example 26 | Example 27 | Example 28 | Example 29 |
| Component (p) | 0 | 0.2 | 0.4 | 0.5 | 0.6 | 0.8 | 1 |
| Relative intensity | 0.812 | 0.843 | 1 | 0.972 | 0.621 | 0.209 | 0.044 |

Firstly, as shown in the enclosed Fig. 8, it could be found that when Ba ion was substituted with Sr ion by increasing the component (p value) of Sr, the red-shift was occurred. In addition, it could be found from the present Examples that it should be p < 1 because the light-emitting phenomenon was not appeared in the case of p=1. In addition, it could be known from the present Examples that as shown in the above [Table 7], the excellent luminescence intensity was appeared at 0.2 ≤ p ≤ 0.5, and in the case of p=0.4, that is, Ba : Sr = 0.6 : 0.4, the best property could be obtained.

[Examples 30 to 36]

Preparation of Phosphor having Components (Ba_{0.5}Sr_{0.5}) Si_{0.56}ON₀.₇₅: xEu²⁺, yRe³⁺, 0.04Cl⁻ (Preparation of Phosphor According to Concentrations of Eu²⁺ and Re³⁺)

In order to confirm the luminescence intensity according to the concentrations (x value, y value) of Eu and Re (Pr) by substituting a part of the activator, Eu with the auxiliary, Re (Pr), the same method with the Example 1 was used except for replacing some of Eu₂O₃ content with Pr₆O₁₁ for making the raw materials. Specifically, x value and y value of the above Chemical Formula were changed by changing the contents of Eu₂O₃ and Pr₆O₁₁ as shown in the following [Table 8] according to each of the Examples.

The phosphors prepared according to the present Examples 30 to 36 had the components of Chemical Formula, (Ba_{0.5}Sr_{0.5}) Si_{0.56}ON_{0.75}: 0.075Eu²⁺, yRe³⁺, 0.04Cl⁻ (Re = Pr). The luminescence relative intensities (λₑₓₙ=460 nm) were measured to the phosphors prepared according to the Examples, and then the results thereof were shown in the following [Table 8] and the enclosed Fig. 9. At this time, the relative intensities shown in [Table 8] and Fig. 9 were based on Example 1 (Intensity=1) that was x=0.075 and y=0.0.

**[Table 8]**

| <Luminescence Relative Intensity According to Component Ratio(x,y) of Activator Eu and Auxiliary Pr> | | | | | | | | | |
|---|---|---|---|---|---|---|---|---|---|
| Note | | Example 1 | Example 30 | Example 31 | Example 32 | Example 33 | Example 34 | Example 35 | Example 36 |
| Eu₂O₃ Content (mmol) | | 0.15 | 0.145 | 0.14 | 0.13 | 0.12 | 0.10 | 0.08 | 0.05 |
| Pr₆O₁₁ content (mmol) | | 0 | 0.005 | 0.01 | 0.02 | 0.03 | 0.05 | 0.07 | 0.10 |
| Component | x | 0.075 | 0.0725 | 0.07 | 0.065 | 0.06 | 0.05 | 0.04 | 0.025 |
| | y | 0 | 0.0075 | 0.015 | 0.03 | 0.045 | 0.075 | 0.105 | 0.15 |
| Relative intensity | | 1 | 0.94 | 1.2 | 1.12 | 1.2 | 0.63 | 0.92 | 0.32 |

As shown in the above [Table 8] and enclosed Fig. 9, it could be found that when some of Eu was substituted with Pr, the excellent luminescence intensity was appeared at a certain range as compared with non-substitution (y=0), and when the substituted amount of Pr was too many, it was decreased. It could be found from the present Examples that as shown in the above [Table 8] and enclosed Fig. 9, it had a good property when the component of Pr (y value) was 0.0 ≤ y ≤ 0.1. In addition, it could be found from the present Examples that some of Eu was substituted with Pr, but the component of Pr (y value) was especially 0.015 ≤ y ≤ 0.045 thereby giving a very excellent property.

[Examples 37 to 42]

Preparation of Phosphor having Components of [(Ba_{0.5}Sr_{0.5}) Si_{0.56}ON_{0.75}: 0.075Eu²⁺, yRe³⁺, 0.04Cl⁻ (Preparation of Phosphor According to Concentration of Re³⁺)

In order to confirm the luminescence intensity according to the concentration change of Re³⁺ (y value) when fixing the activator, Eu²⁺ concentration (Fixing x=0.075), the same method with the Example 1 was used except for changing the content of Pr₆O₁₁ for making each of the raw materials. Specifically, y value of the above Chemical Formula was changed by changing the content of Pr₆O₁₁ as shown in the following [Table 9] according to each of the Examples.

The phosphors prepared according to the present Examples 37 to 42 had the components of Chemical Formula, (Ba_{0.5}Sr_{0.5}) Si_{0.56}ON_{0.75}: 0.075Eu²⁺, yRe³⁺, 0.04Cl⁻ (Re=Pr). The luminescence relative Intensities (λₑₓₙ=460 nm) were measured to the phosphors prepared according to each of the Examples, and then the results thereof were shown in the following [Table 9] and enclosed Fig. 10. At this time, the relative intensity was based on Example 1 (Intensity=1) that was y=0 as shown in [Table 9] and Fig. 10.

**[Table 9]**

| <Luminescence Relative Intensity According to Component Ratio(y) of Auxiliary Pr> | | | | | | | | |
|---|---|---|---|---|---|---|---|---|
| Note | | Example 1 | Example 37 | Example 38 | Example 39 | Example 40 | Example 41 | Example 42 |
| Eu₂O₃ Content (mmol) | | 0.15 | 0.15 | 0.15 | 0.15 | 0.15 | 0.15 | 0.15 |
| Pr₆O₁₁ Content (mmol) | | 0 | 0.005 | 0.01 | 0.02 | 0.03 | 0.05 | 0.07 |
| Component | x | 0.075 | 0.075 | 0.075 | 0.075 | 0.075 | 0.075 | 0.075 |
| | y | 0 | 0.0075 | 0.015 | 0.03 | 0.045 | 0.075 | 0.105 |
| Relative Intensity | | 1 | 1.05 | 1.20 | 1.18 | 1.12 | 1.06 | 0.85 |

As shown in the above [Table 9] and enclosed Fig. 10, it could be known that the excellent luminescence intensity was appeared at a certain range when adding the auxiliary, Re (=Pr) as compared with when not adding (y=0), and when the added amount of Re (=Pr) was too many thereby decreasing the luminescence intensity. Especially, it could be found from the present Examples that for the components of (Ba_{0.5}Sr_{0.5}) Si_{0.56}ON_{0.75}: 0.075Eu²⁺, yRe³⁺, 0.04Cl⁻, it could have an excellent property in the case of 0.0075 ≤ y ≤ 0.075 as compared with when not adding (y=0), and very excellent property in the case of 0.015 ≤ y ≤ 0.045.

<Preparation of Light-Emitting Diode Device>

A light-emitting diode device (Light-Emitting Device) was prepared by using the phosphor according to the Examples as follows:

LED having a blue light was prepared by forming as the following layers on a sapphire substrate in order, respectively: in the order of GaN Nucleation Layer of 25 nm, n-GaN Layer (Metal:Ti/Al) of 1.2 µm, five layers of InGaN/GaN Multi-Quantum Well Layers, InGaN Layer of 4 nm, GaN Layer of 7 nm, and p-GaN Layer (Metal:Ni/Au) of 0.11 µm. And then, the light-emitting diode device was prepared by distributing the phosphor (Green Color) prepared in the above Example 1 on the surface of the blue light LED to epoxy. The light-emitting spectra of the prepared light-emitting diode device were shown in the enclosed Fig. 11. As shown in Fig. 11, it could be found that the light-emitting diode device applied with the phosphor according to the present invention had the blue luminescence band having a peak point at 452 nm that was relevant to the light-emitting band of GaN Blue LED and main light-emitting peak at 525 nm that was emitted from a green phosphor. At this time, when a red color was further added to the above device, a white light could be implemented.

[Examples 43 to 50]

Preparation of Phosphor of (A_{(1-p-q)} BₚC_{q})Si_{0.56}ON_{0.75}:0.075Eu²⁺, 0.04Cl⁻ (Preparation of Phosphor According to Component Ratio of B and C)

In order to confirm the luminescence intensity according to the component ratio (p value, q value) of B and C in the above Chemical Formula, the same method with the Example 1 was used except for changing the use and reaction temperature of each of the raw materials. Specifically, A=Sr was fixed, and it should be contented with B=Ba and C=Ca in Chemical Formula, but p and q values were changed by changing the ratio of Ba and Ca as shown in the following [Table 10]. And, the temperature in the calcinations furnace was settled at 1000 °C. At this time, SrCO₃ and BaCO₃ were used as the precursors of Sr and Ba, respectively, but Ca₃N₂ was used as Ca precursor. The component ratio of Ba and Ca (p value, q value) according to each of the Examples was shown in the following [Table 11]. In addition, when using Si₃N₄, a-phase and β-phrase were used differently according to each of the Examples as shown in the following [Table 11].

The phosphor prepared according to the present Examples 43 to 50 had the components of (Sr _{(1-p-q}) BaₚCa_{q})Si_{0.56}ON₀.₇₅:0.075Eu²⁺, 0.04Cl⁻ (0 ≤ p ≤ 0.5, 0 ≤ q ≤ 0.5). The luminescence relative intensities (λₑₓₙ=460 nm) were measured to the phosphors prepared according to each of the Examples, and then the results thereof were shown in the following [Table 11]. At this time, the relative intensity of the following [Table 11] was based on Example 43 (p=0.5, q=0) (Intensity=1). And, the enclosed Figs. 12 and 13 shown the luminescence (λₑₓₙ=460 nm) and the excitation (λₑₘₛ=526 nm) spectra of the phosphors according to the present Examples.

**[Table 10]**

| <Component of Phosphor According to Examples 43 - 50 > | | | |
|---|---|---|---|
| Component | Weight (g) | mol | MW (g/mol) |
| SrCO₃ | 0.2953g | 2 mmol | 147.63 |
| BaCO₃ | Ratio Change with Ca | | 197.35 |
| Ca₃N₂ | Ratio Change with Ba | | 148.25 |
| Si₃N₄ | 0.1053g | 0.75 mmol | 140.29 |
| BaCl₂(flux) | 0.0173g | 0_{.}08 mmol | 208.25 |
| Eu₂CO₃ | 0.0528g | 0.15 mmol | 351.93 |

**[Table 11]**

| <Luminescence Relative Intensity of Phosphor According to Examples 43 - 50> | | | |
|---|---|---|---|
| Note | Components of Ba and Ca (p value, q value) | Relative Intensity | Si₃N₄ phase |
| Example 43 | Ba : Ca = 0.5 : 0.0 | 1 | α |
| Example 44 | Ba : Ca = 0.4 : 0.1 | 0.31 | α |
| Example 45 | Ba : Ca = 0.3 : 0.2 | 0.21 | α |
| Example 46 | Ba : Ca = 0.2 : 0.3 | 0,12 | α |
| Example 47 | Ba : Ca = 0.1 : 0.4 | 0.06 | α |
| Example 48 | Ba : Ca = 0.0 : 0.5 | 0.03 | α |
| Example 49 | Ba : Ca = 0.3 : 0.2 | 0.13 | β |
| Example 50 | Ba : Ca = 0.5 : 0.0 | 0.39 | β |

Firstly, as shown in the enclosed Fig. 13, it could be found that the red-shift was occurred when Ba ion was substituted with Ca ion. In addition, as shown in the above [Table 11], it could be found that when fixing A=Sr and substituting Ba with Ca according to the present Examples, for the mole ratio (Component Ratio) of Ba and Ca, it had the relatively good luminescence intensity, in which the relative intensity was relatively good, i.e., above 0.3 in the case of 0.4 ≤ p. It could be also found that for Si₃N₄, a-phase had better value as compared with ß-phase.

[Examples 51 to 56]

Preparation of Phosphor of (A_{(1-p-q)}BₚC_{q})Si_{0.56}ON_{0.75}:0.075Eu²⁺, 0.04Cl⁻ (Preparation of Phosphor According to Component Ratio of B and C)

In order to confirm the luminescence intensity according to the component ratio (p value, q value) of B and C in the Chemical Formula, the same method with the above Example 43 was used except for changing the use and the reaction temperature of each of the raw materials. Specifically, B=Sr was fixed, and A=Ba or Ca and C=Ca or Ca should be fixed in the Chemical Formula, but p and q values were changed by changing the ratio of Sr, Ba, and Ca as shown in the following [Table 12]. And, the temperature in the calcinations furnace was settled at 900 °C. The component ratio (p value, q value) of B and C according to each of the Examples was shown in the following [Table 13].

The phosphors prepared according to the present Examples 51 to 56 had the components of (A_{(1-p-q}) SrₚC_{q})Si_{0.56}ON_{0.75}:0.075Eu²⁺, 0.04Cl⁻ (0 ≤ p ≤ 0.5, 0 ≤ q ≤ 0.5, A = Ba or Ca, and C = Ca or Ba). The luminescence relative intensities (λₑₓₙ=460 nm) were evaluated to the phosphors prepared according to each of the Examples, and then the results thereof were shown in the following [Table 13]. At this time, the relative intensity in the following [Table 13] was based on Example 51 (p=0.5, q=0) (Intensity=1). Example 51 in the following [Table 13] used the same phosphor specimen with the Example 1. And, the enclosed Figs. 14 and 15 shown the luminescence (λₑₓₙ=460 nm) and excitation (λₑₘₛ=550 nm) spectra of the phosphors according to each of the Examples, respectively.

**[Table 12]**

| <Component of Phosphor According to Examples 51 ~ 56> | | | |
|---|---|---|---|
| Component | Weight (g) | mol | MW (g/mol) |
| BaCO₃ | Ratio Change with Sr | | 197.35 |
| SrCO₃ | Ratio Change with Ca | | 147.63 |
| Ca₃N₂ | Ratio Change with Sr | | 148.25 |
| Si₃N₄ | 0.1053g | 0.75 mmol | 140.29 |
| BaCl₂(flux) | 0.0173g | 0.08 mmol | 208.25 |
| Eu₂CO₃ | 0.0528g | 0.15 mmol | 351.93 |

**[Table 13]**

| <Luminescence Relative Intensity of Phosphor According to Examples 51 ~ 56 > | | | |
|---|---|---|---|
| Note | Components of B and C (p value, q value) | A | Relative intensity |
| Example 51 | Sr : Ca = 0.5 : 0.0 | Ba | 1 |
| Example 52 | Sr : Ca = 0.4 : 0.1 | Ba | 0.31 |
| Example 53 | Sr : Ca = 0.3 : 0.2 | Ba | 0.21 |
| Example 54 | Sr : Ca = 0.2 : 0.3 | Ba | 0.12 |
| Example 55 | Sr : Ba = 0.1 : 0.4 | Ca | 0.06 |
| Example 56 | Sr : Ba = 0.0 : 0.5 | Ca | 0.03 |

As shown in the above [Table 13], when fixing B=Sr and substituting B (Sr) with C (Ba or Ca) according to the present Examples, for the mole ratio (Component Ratio) of B and C, the relatively good luminescence intensity could be obtained as above 0.3 of relative intensity in the case of 0.4 ≤ p.

[Examples 57 and 62]

Preparation of Phosphor of (A_{(1-p-q)}BₚCq)Si_{0.56}ON_{0.75}:0.075Eu²⁺, 0.04Cl⁻ (Preparation of Phosphor According to Component Ratio and Types of B and C)

In order to confirm the luminescence intensity according to the component ratio (p value, q value) and a type of B and C in the above Chemical Formula, the same method with the Example 43 was used except for changing each of the raw materials. Specifically, A=Ba was fixed and it is allowed to be B=Sr and C=Mg, but p and q values were changed by changing the ratio of Sr and Ma as shown in the following [Table 14]. The component ratio of Sr and Mg (p value, q value) according to each of the Examples were shown in the following [Table 15].

The phosphors prepared according to the present Examples 57 to 62 had the components of (Ba_{(1-p-q}) SrₚMg_{q})Si_{0.56}ON_{0.75}:0.075Eu²⁺, 0.04Cl⁻ (0 ≤ p ≤ 0.5, 0 ≤ q ≤ 0.5). The luminescence relative intensities (λₑₓₙ=400 nm) were measured to the phosphors prepared according to each of the Examples, and then the results thereof were shown in the following [Table 15] and enclosed Fig. 16. At this time, the relative intensities of [Table 15] and Fig. 16 were based on Example 57 (p=0.5, q=0) (Intensity=1), and Example 57 used the same phosphor specimen with the Example 1.

**[Table 14]**

| <Component of Phosphor According to Examples 57 ~ 62 > | | | |
|---|---|---|---|
| Component | Weight (g) | mol | MW (g/mol) |
| BaCO₃ | 0.3947g | 2 mmol | 197.35 |
| SrCO₃ | Ratio Change with Mg | | 147.63 |
| Mg₃N₂ | Ratio Change with Sr | | 100.95 |
| Si₃N₄ | 0.1053g | 0.75 mmol | 140.29 |
| BaCl₂(flux) | 0.0173g | 0.08 mmol | 208.25 |
| Eu₂CO₃ | 0.0528g | 0.15 mol 1 | 351.93 |

**[Table 15]**

| <Luminescence Relative Intensity of Phosphor According to Examples 57 -62 > | | |
|---|---|---|
| Note | Components of Sr and Mg (p value, q value) | Relative Intensity |
| Example 57 | Sr : Mg = 0.5 : 0.0 | 1 |
| Example 58 | Sr : Mg = 0.4 : 0.1 | 4.22 |
| Example 59 | Sr : Mg = 0.3 : 0.2 | 4.61 |
| Example 60 | Sr : Mg = 0.2 : 0.3 | 4.38 |
| Example 61 | Sr : Mg = 0.1 _{:} 0.4 | 3.98 |
| Example 62 | Sr : Mg = 0.0 : 0.5 | 2.51 |

As shown in the above [Table 15] and enclosed Fig. 16, A=Ba was fixed and B=Sr was used according to the present Examples, but it could be found that in the case of using C=Mg, it had the excellent luminescence intensity. That is, it could be known that Mg was used as C, but in the case of 0 < q, the luminescence intensity could be improved. And, it could be found from the present Examples that B=Sr was used but when adding Mg as C, the excellent luminescence intensity could be obtained in the case of 0.1 ≤ q ≤ 0.5 as above 2.5 of the relative intensity as compared with that of not adding (q=0).

In addition, it could be found from the present Examples that when replacing Sr with Mg, the excellent luminescence intensity could be obtained. That is, it could be known like the Example 62 that when Mg was used instead of Sr, and Sr was not used, the excellent luminescence intensity could be obtained as above 2.5 of the relative intensity as compared with Example 57. At this time, the Chemical Formula may be represented by (A_{(1-p-q}) BₚC_{q})Si_{0.56}ON_{0.75}:0.075Eu²⁺, 0.04Cl⁻ (A=Ba, B=Mg, 0 < p < 1.0, q=0), and more specifically, (Ba₍₁₋ₚ₎Mgₚ) Si_{0.56}ON_{0.75}:0.075Eu²⁺, 0.04Cl⁻ (0 < p < 1.0).

[Examples 63 to 65]

Preparation of Phosphor of (Ba_{0.5}Sr_{0.5}) D_{b}Si_{0.56}ON _{0.75}:0.075Eu²⁺, 0.04Cl⁻ (Preparation of Phosphor According to Addition of D)

In order to confirm the luminescence intensity according to the addition amount (b value) of element D of Group 3, the same method with the Example 1 was used except for changing the use and the reaction temperature of each of the raw materials. Specifically, BN was further added as D precursor as compared with the Example 1, but b value was changed by changing the ratio of D (=B) as shown in the following [Table 16]. And, the temperature in the calcinations furnace was settled at 1000 °C. The component ratio (b value) of D (=B) according to each of the Examples was shown in the following [Table 17].

The phosphors prepared according to the present Examples 63 to 65 had the components of (Ba_{0.5}Sr_{0.5})B_{b}Si_{0.56}ON_{0.75}:0.07SEu²⁺, 0.04Cl⁻ (₀ ≤ b ≤ 1.0). The luminescence relative intensities (λₑₓₙ=460 nm) were evaluated to the phosphors prepared according to each of the Examples, and then the results thereof were shown in the following [Table 17] and enclosed Fig. 17. At this time, the relative intensities shown in [Table 17] and Fig. 17 were based on Example 1 (b=0) (Intensity=1) that was not added with D (=B).

**[Table 16]**

| <Component of Phosphor According to Examples 63 ~ 65> | | | |
|---|---|---|---|
| Component | Weight (g) | mol | MW (_{g/mol}) |
| BaCO₃ | 0.3974g | 2 mmol | 197.35 |
| SrCO₃ | 0.2953g | 2 mmol | 147.63 |
| BN | Mol Number Change (0 ~ 2 mmol) | | 24.82 |
| Si₃N₄ | 0.1053g | 0.75 mmol | 140.29 |
| BaCl₂(flux) | 0.0173g | 0.08 mmol | 208.25 |
| Eu₂CO₃ | 0.0528g | 0.15 mmol | 351.93 |

**[Table 17]**

| < Luminescence Relative Intensity of Phosphor According to Examples 63 ~ 65 > | | |
|---|---|---|
| Note | Component of D(=B)(b value) | Relative Intensity |
| Example 1 | 0 | 1 |
| Example 63 | 0.25 | 1.16 |
| Example 64 | 0.5 | 1.02 |
| Example 65 | 1 | 0.49 |

As shown in the above [Table 17] and enclosed Fig. 17, it could be found that the luminescence intensity was depended on whether or not the element of Group 3 D (=B) was added, and the added amount. For the present Examples, when adding D (=B), the excellent luminescence intensity could be obtained in the case of 0.25 ≤ b ≤ 0.5 rather than that of not adding (b=0) to (Ba_{0.5}Sr_{0.5}), and the best property could be obtained in the case of b=0.25.

[Examples 66 to 68]

Preparation of Phosphor of (Ba_{0.5}Sr_{0.5})D_{b}Si_{0.56}ON_{0.75}:0.075Eu²⁺, 0.04Cl⁻ (Preparation of Phosphor According to Type of D)

In order to confirm the luminescence intensity according to a type of element D of Group 3, the same method with the Example 63 was used except for using other type of D precursor. Specifically, AlN was used as D precursor and its added amount (Mole Number Change, 0 ~ 2 mmol) was changed as compared to Example 63. The component ratio (b value) of D (=Al) according to each of the Examples was shown in the following [Table 18].

The phosphors prepared according to the present Examples 66 to 68 had the components of (Ba_{0.5}Sr₀.₅)Al_{b}Si_{0.56}ON_{0.75}:0.075Eu²⁺, 0.04Cl⁻ (0 ≤ b ≤ 1.0). The luminescence relative intensities (λₑₓₙ=460 nm) were measured to the phosphors prepared according to each of the Examples, and then the results thereof were shown in the following [Table 18] and enclosed Fig. 18. At this time, the relative intensities shown in [Table 18] and Fig. 18 was based on Example 1 (b=0) (Intensity=1) that was not added with D (=Al).

**[Table 18]**

| < Luminescence Relative Intensity of Phosphor According to Examples 66 ~ 68 > | | |
|---|---|---|
| Note | Component of D(= Al)(b value) | Relative Intensity |
| Example 1 | 0 | 1 |
| Example 66 | 0.25 | 0.34 |
| Example 67 | 0.5 | 0.65 |
| Example 68 | 1 | 0.26 |

As shown in the above [Table 18] and enclosed Fig. 18, it could be found that the luminescence intensity was depended on whether or not the element D (=Al) of Group 3 was added, and the added amount. When Al was used as D according to the present Examples, good luminescence intensity could be obtained in the case of b=0 or 0.5 rather than in the case of b=0.25 or 1 to (Ba_{0.5}Sr_{0.5}).

[Examples 69 to 71]

Preparation of Phosphor of (Ba_{0.5}Sr_{0.5}) D_{b}Si_{0.56}ON_{0.75}:0.075Eu²⁺, 0.04Cl⁻ (Preparation of Phosphor According to Type of D)

In order to confirm the luminescence intensity according to a type of element D of Group 3, the same method with the Example 63 was used except for using other type of D precursor. Specifically, GaN was used as D precursor and its added amount (Mole Number Change, 0 - 2 mmol) was different from Example 63. The component ratio (b value) of D (=Ga) according to each of the Examples was shown in the following [Table 19].

The phosphors prepared according to the present Examples 69 to 71 had the components of (Ba_{0.5}Sr_{0.5})Ga_{b}Si_{0.56}ON_{0.75}:0.075Eu²⁺, 0.04Cl⁻ (0 ≤ b ≤ 1.0). The luminescence relative intensities (λₑₓₙ=460 nm) were evaluated to the phosphors according to each of the Examples, and then the results thereof were shown in the following [Table 19] and enclosed Fig. 19. At this time, the relative intensity shown in [Table 19] and Fig. 19 was based on Example 1 (b=0) (Intensity=1) that was not added with D (=Ga).

**[Table 19]**

| < Luminescence Relative Intensity of Phosphor According to Examples 69 ~ 71 > | | |
|---|---|---|
| Note | Component of D(=Ga)(b value) | Relative Intensity |
| Example 1 | 0 | 1 |
| Example 69 | 0.25 | 0.21 |
| Example 70 | 0.5 | 0.11 |
| Example 71 | 1 | 0.07 |

As shown in the above [Table 19] and enclosed Fig. 19, it could be found that the luminescence intensity was depended on whether or not the element D (=Ga) of Group 3 was added, and the added amount. It could be found from the present Examples that when Ga was used as D, good luminescence intensity could be obtained in the case of b=0 or 0.25 rather than that in the case of b=0.5 or 1 to (Ba_{0.5}Sr_{0.5}).

[Examples 72 to 74]

Preparation of Phosphor of (Ba_{0.5}Sr_{0.5}) D_{b}Si_{0.56}ON_{0.75}:0.075Eu²⁺, 0.04Cl⁻ (Preparation of Phosphor According to Type of D)

In order to confirm the luminescence intensity according to a type of the element D of Group 3, the same method with the Example 63 was used except for using other type of D precursor. Specifically, LaN was used as D precursor and its added amount (Mole Number Change, 0~2 mmol) was changed as compared with Example 63. The component ratio (b value) of D (=La) according to each of the Examples was shown in the following [Table 20].

The phosphors prepared according to the present Examples 72 to 74 had the components of (Ba_{0.5}Sr_{0.5})La_{b}Si_{0.56}ON_{0.75}:0.075Eu²⁺, 0.04Cl⁻ (0 ≤ b ≤ 1.0). The luminescence relative intensities (λₑₓₙ=460 nm) were measured to the phosphors prepared according to each of the Examples, and then the results thereof were shown in the following [Table 20] and enclosed Fig. 20. At this time, the relative intensities shown in [Table 20] and Fig. 20 were based on Example 1 (b=0) (Intensity=1) that was not added with D (=La).

**[Table 20]**

| < Luminescence Relative Intensity of Phosphor According to Examples 72 ~ 74 > | | |
|---|---|---|
| Note | Component of D(=La)(b value) | Relative Intensity |
| Example 1 | 0 | 1 |
| Example 72 | 0.25 | 1.05 |
| Example 73 | 0.5 | 1.38 |
| Example 74 | 1 | 0.96 |

As shown in the above [Table 20] and enclosed Fig. 20, it could be found that the luminescence intensity was depended on whether or not the element D (=La) of Group 3 was added, and the added amount. It could be found from the present Examples that when La was used as D, the excellent luminescence intensity could be obtained in the case of 0.25 ≤ b ≤ 0.5 rather than that in the case of not adding (b=0) to (Ba_{0.5}Sr_{0.5}), and the best property could be obtained in the case of b=0.5.

[Examples 75 to 81]

Preparation of Phosphor of (Ba_{0.5}Sr_{0.5})Si_{0.56}ON_{0.75}:0.075Eu²⁺, 0.04Q (Preparation of Phosphor According to Type of Q)

In order to confirm the luminescence intensity according to a type of Q as the flux, the same method with the Example 1 was used, except for changing Q precursor. And, the reaction temperature was settled at 1000 °C. Types of Q precursor according to each of the Examples were shown in the following [Table 21].

The phosphors prepared according to the present Examples 75 to 81 had the components of (Ba_{0.5}Sr_{0.5})Si_{0.56}ON_{0.75}:0.075Eu²⁺, 0.04Q (Q = Cl, F, Br, B). The luminescence relative intensities (λₑₓₙ=460 nm) were measured to the phosphors prepared according to each of the Examples, and then the results thereof were shown in the following [Table 21] and enclosed Fig. 21. At this time, the relative intensities shown in [Table 21] and Fig. 21 were based on Example 1 (Q=Cl) (Intensity=1) that was used with BaCl₂ as Q precursor.

**[Table 21]**

| < Luminescence Relative Intensity of Phosphor According to Examples 75 ~ 81 > | | |
|---|---|---|
| Note | Q Precursor (z=0.04) | Relative Intensity |
| Example 1 | BaCl₂ | 1 |
| Example 75 | BaF₂ | 0.92 |
| Example 76 | NH₄Cl | 0.28 |
| Example 77 | NH₄f | 0.74 |
| Example 78 | B₂O₂ | 0.46 |
| Example 79 | NaCl | . 0.64 |
| Example 80 | NaBr | 1.25 |
| Example 81 | BaCl₂ + NaCl | 0.83 |

As shown in the above [Table 21] and enclosed Fig. 21, it could be known that the luminescence intensity was depended on a type of flux (Q precursor). It could be found that the halogen salt was used as Q precursor in the present Examples, but when using BaCl₂, BaF₂, and NaBr, the relative intensity was favorably evaluated as above 0.9 and when using NaBr, the most excellent evaluation was obtained.

[Examples 82 to 92]

Preparation of Phosphor having Components of (Ba_{0.5}Sr_{0.5})Si_{0.56}ON_{0.75}:xEu²⁺, yRe³⁺, 0.04Cl⁻ (Preparation of Phosphor According to Type of Re³⁺)

Some of activator, Eu was substituted with the auxiliary, Re, but in order to confirm the luminescence intensity according to a type of Re, the same method with the Example 1 was used except for further adding various types of Re precursors for making the raw materials. Specifically, a type of Re in the above Chemical Formula was changed by further adding Re precursors as shown in the following [Table 22] according to each of the Examples. And, the reaction temperature was settled at 1000 °C. In addition, Eu precursor and Re precursor in the above Chemical Formula were used in the same amount each other (Eu₂O₃=0.15 mmol, Re precursor=0.03 mmol) to fix x = 0.075 and y = 0.045.

The phosphors prepared according to the present Examples 82 to 92 had the components of Chemical Formula, (Ba_{0.5}Sr_{0.5})Si_{0.56}ON_{0.75}:0.075Eu²⁺, 0.045Re³⁺, 0.04Cl⁻ (Re = Ce, Pr, Gd, Tb, Dy, Ho, Er, Nd, Sm, Yb). The luminescence relative intensities (λₑₓₙ=460 nm) were measured to the phosphors prepared according to the Examples, and than the results thereof were shown in the following [Table 22] and enclosed Fig. 22. At this time, the relative intensities shown in [Table 22] and Fig. 22 were based on Example 1 (x = 0.075, y = 0.0) (Intensity = 1) that was not added with Re.

**[Table 22]**

| < Luminescence Relative Intensity of Phosphor According to Examples 82 ~ 92 > | | |
|---|---|---|
| Note | Re Precursor (y=0.045) | Relative Intensity |
| Example 1 | - | 1 |
| Example 82 | CeO₂ | 0.69 |
| Example 83 | Pr₆O₁₁ | 1.01 |
| Example 84 | Pr₂O₃ | 0.69 |
| Example 85 | Gd₂O₃ | 1.02 |
| Example 86 | Tb₄O₇ | 1.03 |
| Example87 | Dy₂O₃ | 1.02 |
| Example88 | Ho₂O₃ | 0.88 |
| Example89 | Er₂O₃ | 0.89 |
| Example90 | Nd₂O₃ | 0.00 |
| Example91 | Sm₂O₃ | 0.39 |
| Example 92 | Yb₂O₃ | 1.05 |

As shown in the above [Table 22] and enclosed Fig. 22, it could be found that the luminescence intensity was depended on a type of Re. In addition, it could be found from the present Examples that when using Pr₆O₁₁, Gd₂O₃, Tb₄O₇, Dy₂O₃, and Tb₂O₃ as Re precursor, that is, in the case of Re = Pr, Gd, Tb, Dy, and Tb, the excellent luminescence intensity could be obtained rather than that in the case of not adding (Example 1, y=0).

## Claims

1. An oxynitride phosphor comprising crystals represented by the following Chemical Formula:
[Chemical Formula] (A_{(1-p-q)}BₚC_{q})ₐD_{b}Si_{c}O_{d}Nₑ: xEu²⁺, yRe³⁺, zQ
(In the above Chemical Formula,
A, B, and C are +2 metals, but different metals from one another;
D is metals of Group 3;
Re is +3 metals;
Q is a flux;
p and q are 0 < p < 1.0 and 0 ≤ q < 1.0;
a, b, c, d, and e are 1.0 ≤ a ≤ 2.0, 0 ≤ b ≤ 4.0, 0 < c ≤ 1.0, 0 < d ≤ 1.0, and 0 < e ≤ 2.0; and
x, y, and z are 0 < x ≤ 0.25, 0 ≤ y ≤ 0.25, and 0 ≤ z ≤ 0.25)

2. The oxynitride phosphor according to claim 1, wherein x in the Chemical Formula is contented with 0.025 ≤ x ≤ 0.12.

3. The oxynitride phosphor according to claim 1, wherein y in the above Chemical Formula is contented with 0.0075 ≤ y ≤ 0.1.

4. The oxynitride phosphor according to claim 1, wherein z in the above Chemical Formula is contented with 0.02 ≤ z ≤ 0.15.

5. The oxynitride phosphor according to claim 1, wherein x in the above Chemical Formula is contented with 0.025 ≤ x ≤ 0.12, y is contented with 0.0075 ≤ y ≤ 0.1, and z is contented with 0.02 ≤ z ≤ 0.15.

6. The oxynitride phosphor according to claim 1, wherein p in the above Chemical Formula is contented with 0.2 ≤ p ≤ 0.5.

7. The oxynitride phosphor according to claim 1, wherein q in the above Chemical Formula is contented with 0.1 ≤ q ≤ 0.5.

8. The oxynitride phosphor according to claim 1, wherein b in the above Chemical Formula is contented with 0 < b ≤ 1.0.

9. The oxynitride phosphor according to claim 1, wherein c in the above Chemical Formula is contented with 0.3 ≤ c ≤ 0.9 and e is contented with 0.4 ≤ e ≤ 1.2.

10. The oxynitride phosphor according to claim 1, wherein A, B, and C in the above Chemical Formula are more than one selected from the group consisting of Be, Mg, Ca, Sr, Ba, Ra, Zn, Cd, Hg, Pb, Sn, and Ge.

11. The oxynitride phosphor according to claim 1, wherein D in the above Chemical Formula is more than one selected from the group consisting of B, Al, Ga, In, Ti, Sc, Y, La, Ce, Pr, Nd, Pm, Sm, Gd, Tb, Dy, Ho, Er, Tm, Yb, and Lu.

12. The oxynitride phosphor according to claim 1, wherein Re in the above Chemical Formula is more than one selected from the group consisting of La, Ce, Pr, Nd, Pm, Sm, Gd, Tb, Dy, Ho, Er, Tm, Yb, and Lu.

13. The oxynitride phosphor according to claim 1, wherein Q in the above Chemical Formula is halogen elements.

14. The oxynitride phosphor according to claim 1, wherein A and B in the above Chemical Formula are more than one selected from the group consisting of Be, Ca, Sr, Ba, Ra, Zn, Cd, Hg, Pb, Sn, and Ge, and q in the above Chemical Formula is contented with 0 < q < 0.6.

15. The oxynitride phosphor according to claim 1, wherein A in the above Chemical Formula is more than one selected from the group consisting of Be, Ca, Sr, Ba, Ra, Zn, Cd, Hg, Pb, Sn, and Ge, B is Mg, and p and q in the above Chemical Formula are contented with 0 < p < 0.6 and q = 0, respectively.

16. The oxynitride phosphor according to claim 1, wherein a size of the phosphor is 1 - 30µm.

17. A method for preparing the oxynitride phosphor according to claim 1, comprising:
First step for mixing A precursor (A is +2 metals), B precursor (B is +2 metals, but different metals from A), C precursor (C is +2 metals, but different metals from A and B), D precursor (D is elements of Group 3), Si precursor, N precursor, Eu precursor, Re precursor (Re is +3 metals), and Q precursor (Q is the flux) by controlling the contents of each of the precursors to be contented with the above Chemical Formula; and
Second step for calcining the raw materials by injecting the raw materials in a calcinations furnace.

18. The method for preparing the oxynitride phosphor according to claim 17, wherein the second step comprises
a) step for increasing a temperature to 800 °C ~ 1300°C while injecting an ammonia gas inside the calcinations furnace in 5 - 15 mL/min; and
b) step for maintaining at the temperature of 800□ ~ 1300□ for 2~5 hours in the presence of the ammonia gas.

19. The method for preparing the oxynitride phosphor according to claim 17, wherein the A, B, and C precursors are more than one selected from the group consisting of compounds of Be, Mg, Ca, Sr, Ba, Ra, Zn, Cd, Hg, Pb, Sn, and Ge.

20. The method for preparing the oxynitride phosphor according to claim 17, wherein the D precursor is more than one selected from the group consisting of compounds of B, Al, Ga, In, Ti, Sc, Y, La, Ce, Pr, Nd, Pm, Sm, Gd, Tb, Dy, Ho, Er, Tm, Yb, and Lu.

21. The method for preparing the oxynitride phosphor according to claim 17, wherein the Re precursor is more than one selected from the group consisting of compounds of La, Ce, Pr, Nd, Pm, Sm, Gd, Tb, Dy, Ho, Er, Tm, Yb, and Lu.

22. The method for preparing the oxynitride phosphor according to claim 17, wherein the Q precursor is salts of halogen Group.

23. A light-emitting device comprising an excitation light source; and a phosphor, wherein the phosphor includes the oxynitride phosphor according to any one of claims 1 to 13.

24. The light-emitting device according to claim 23, wherein the excitation light source is Light-Emitting Diode (LED), Organic Light-Emitting Diode (OLED), or Laser Diode (LD).

25. The light-emitting device according to claim 23, wherein a light-emitting wavelength of the excitation light source is 350nm ~ 480 nm.
